# EUROPEAN PATENT APPLICATION

(11) **EP 2 708 622 A2**
(43) Date of publication of application: **19.03.2014**
(21) Application number: 13183203.2
(22) Date of filing: 05.09.2013
(51) Int. Cl.: C30B 9/12, C30B 29/40

(54) **Group 13 nitride crystal, group 13 nitride crystal substrate, and method of manufacturing group 13 nitride crystal**

(30) Priority: 17.09.2012 JP 2012203754
(71) Applicant: Ricoh Company Ltd., Tokyo 143-8555 (JP)
(72) Inventor: Hayashi, Masahiro, Tokyo 143-8555 (JP); Satoh, Takashi, Tokyo 143-8555 (JP); Kimura, Chiharu, Tokyo 143-8555 (JP); Miyoshi, Naoya, Tokyo 143-8555 (JP); Murakami, Akishige, Tokyo 143-8555 (JP); Miyake, Shinsuke, Tokyo 143-8555 (JP); Wada, Junichi, Tokyo 143-8555 (JP); Sarayama, Seiji, Tokyo 143-8555 (JP)
(74) Representative: Leeming, John Gerard

(57) **Abstract**

A group 13 nitride crystal (19) having a hexagonal crystal structure contains at least a nitrogen atom and at least one metal atom selected from a group consisting of B, Al, Ga, In and Tl. Dislocation density of basal plane dislocations (P) in a cross section parallel to a c-axis is 10⁴ cm⁻² or more.

## Description

The present application claims priority to and incorporates by reference the entire contents of Japanese Patent Application No. 2012-203754 filed in Japan on September 17, 2012.

The present invention relates to a group 13 nitride crystal, a group 13 nitride crystal substrate, and a method of manufacturing a group 13 nitride crystal.

Gallium nitride (GaN) Semiconductor material is known to be used for blue color light-emitting diode (LED) or white color LED, and a semiconductor device such as semiconductor laser (LD: Laser Diode). As the method of manufacturing a semiconductor device using gallium nitride (GaN) semiconductor material, a method of growing on a substrate a gallium nitride crystal by MO-CVD (Metalorganic Chemical Vapor Deposition) method, MBE (Molecular Beam Epitaxy) method or the like has been known.

As the substrate used to prepare a semiconductor device, a group 13 nitride substrate which is made of the same material as crystal to be grown is suitably used.

As the group 13 nitride substrate used to prepare a semiconductor device, various substrates and manufacturing methods have been disclosed. For example, it is disclosed that gallium nitride crystal is formed by putting and sealing sodium azide (NaN₃) and metal Ga as source materials in a reactor vessel made of stainless material (inside sizes of the vessel, inner diameter is 7.5 mm, length is 100 mm) under a nitrogen atmosphere, and retaining the reactor vessel at a temperature of 600°C to 800°C for 24 to 100 hours (Chemistry of Materials Vol. 9 (1997) 413-416).

Also, an attempt to obtain a further large group 13 nitride crystal has been made. For example, Japanese Laid-open Patent Publication No. 2008-094704 discloses a method of manufacturing a column-like crystal of gallium nitride by using a needle-like crystal of aluminum nitride (AlN) as a seed crystal. Also, Japanese Laid-open Patent Publication No. 2006-045047 discloses a method of manufacturing a needle-like crystal of aluminum nitride.

In addition, an attempt to obtain a further high quality group 13 nitride crystal by reducing the dislocation density and reducing the inclusion content in the crystal has been made. For example, WO09/047894 and the Institute of Electronics, Information and Communication for Engineers, IEICE Tech. Rep. ED96-29, CPM96-14 (1996-05) disclose that a group 13 nitride crystal substrate manufactured by a flux method is heated at such a temperature that an internal flux is discharged. Japanese Laid-open Patent Publication No. 2010-168236 discloses that a crystal is grown at such a crystal growth rate that the amount of the inclusion taken into a crystal when a crystal is grown is reduced. Japanese Laid-open Patent Publication No. 2011-213579 discloses that a needle-like crystal of gallium nitride is used as a seed crystal, whereby a high quality group 13 nitride crystal is obtained.

However, conventionally, while the attempt to obtain a further large group 13 nitride crystal and the attempt to reduce the dislocation density and reduce the inclusion content in the crystal have been made, it has been difficult to shorten the manufacturing time and reduce the cost. Therefore, conventionally, it has been difficult to obtain a substrate suitable for manufacturing a semiconductor device.

In consideration of the above, there is a need to provide a group 13 nitride crystal, a group 13 nitride crystal substrate, and a method of manufacturing a group 13 nitride crystal suitable for manufacturing a semiconductor device.

It is an object of the present invention to at least partially solve the problems in the conventional technology.

A group 13 nitride crystal having a hexagonal crystal structure contains at least a nitrogen atom and at least one metal atom selected from a group consisting of B, Al, Ga, In and Tl. Dislocation density of basal plane dislocations in a cross section parallel to a c-axis is 10⁴ cm⁻² or more.

A method of manufacturing a group 13 nitride crystal includes a crystal growth process of crystal-growing a needle-like seed crystal of group 13 nitride extending in a c-axis direction, in such a direction that a cross-sectional area of a c-plane is enlarged. A crystal growth rate in an a-axis direction of the seed crystal in the crystal growth process is higher than 15 µm/hr.

The above and other objects, features, advantages and technical and industrial significance of this invention will be better understood by reading the following detailed description of presently preferred embodiments of the invention, when considered in connection with the accompanying drawings.

### BRIEF DESCRIPTION OF THE DRAWINGS

FIG. 1 is a rough perspective view illustrating an example of a structure of a group 13 nitride crystal according to the present embodiment;
FIG. 2 is a schematic view illustrating a cross section parallel to the c-axis and a-axis in a group 13 nitride crystal;
FIG. 3 is a cross sectional view of the c-plane cross section of a group 13 nitride crystal;
FIG. 4 is a schematic view illustrating an example of a group 13 nitride crystal;
FIG. 5 is a schematic view illustrating an example of a group 13 nitride crystal;
FIG. 6 is a rough schematic view of a crystal manufacturing apparatus to manufacture a seed crystal;
FIG. 7 is a rough schematic view of a crystal manufacturing apparatus to manufacture a group 13 nitride crystal from a seed crystal;
FIG. 8 is a schematic view illustrating dislocations in a group 13 nitride crystal;
FIG. 9 is a process chart illustrating a manufacturing process of a group 13 nitride crystal substrate;
FIG. 10 is a schematic view illustrating an example of processing a group 13 nitride crystal into a substrate;
FIG. 11 is a schematic view illustrating a direction to slice a group 13 nitride crystal;
FIG. 12 is a schematic view of a group 13 nitride crystal substrate;
FIG. 13 is a schematic view for describing a process to grow a crystal from a seed crystal;
FIG. 14 is a schematic view for describing a process to grow a crystal from a seed crystal;
FIG. 15 is a schematic view for describing a process to grow a crystal from a seed crystal;
FIG. 16 is a schematic view illustrating relationships between the shapes of seed crystals and L/d;
   and
FIG. 17 is a schematic view illustrating an example of a group 13 nitride crystal after polishing.

### DETAILED DESCRIPTION OF THE PREFERRED EMBODIMENTS

Hereinbelow, a group 13 nitride crystal, a group 13 nitride crystal substrate and a method of manufacturing a group 13 nitride crystal, according to the present embodiment will be described, with reference to the accompanying drawings. In the following description, the drawings herein only schematically illustrate shapes, sizes and arrangements of constituents to an extent that the invention can be understood, and the present invention is not particularly limited thereto. Also, identical reference numerals are given to the same or corresponding constituents illustrated in the plurality of drawings, and the redundant explanation may be omitted.

The group 13 nitride crystal of the present embodiment is a group 13 nitride crystal having a hexagonal crystal structure and containing at least a nitrogen atom and at least one metal atom selected from a group consisting of B, Al, Ga, In and Tl. In addition, in the group 13 nitride crystal of the present embodiment, the dislocation density of basal plane dislocations in a cross section parallel to the c-axis is 10⁴ cm⁻² or more.

Basal plane dislocation (BDP) refers to a dislocation in the direction parallel to a c-plane (plane perpendicular to the c-axis). In the group 13 nitride crystal of the present embodiment, the dislocation density of basal plane dislocations in a cross section parallel to the c-axis is 10⁴ cm⁻² or more. Thus, the crystal growth rate, the details of which are described later, in the manufacture of the group 13 nitride crystal can be made faster as compared to the related art.

Therefore, in the present embodiment, a group 13 nitride crystal suitable for manufacturing a semiconductor device can be provided. In addition, a group 13 nitride crystal substrate prepared using the group 13 nitride crystal in the present embodiment is a group 13 nitride crystal substrate suitable for manufacturing a semiconductor device. The phrase "suitable for manufacturing a semiconductor device" specifically refers to being suitable as a seed crystal (substrate that is the basis for crystal growth) used to manufacture a semiconductor device.

Here, examples of the semiconductor device include a semiconductor laser, a light emitting diode and the like, but not limited thereto.

Hereinbelow, a detailed description will be given.

### [1] Group 13 Nitride Crystal

As described above, the group 13 nitride crystal according to the present embodiment is a group 13 nitride crystal having a hexagonal crystal structure and containing at least a nitrogen atom and at least one metal atom selected from a group consisting of B, Al, Ga, In and Tl. Here, the group 13 nitride crystal according to the present embodiment contains, as the metal atom, preferably at least one of Ga and Al, and more preferably at least Ga.

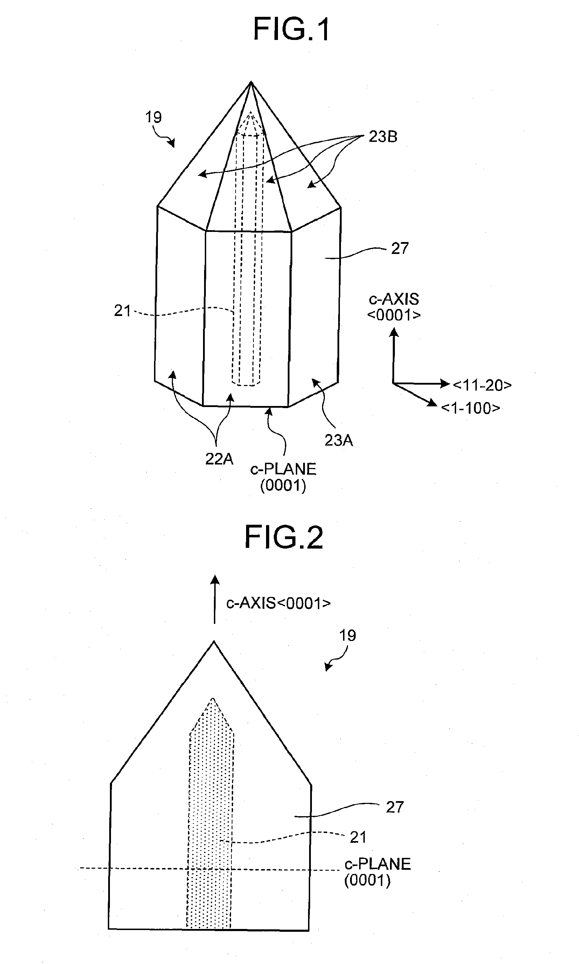

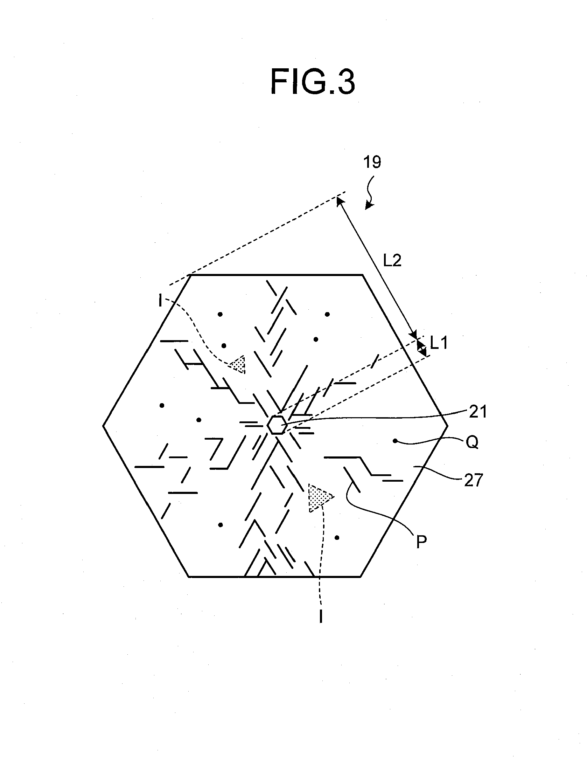

FIGS. 1 to 3 illustrate an example of the group 13 nitride crystal 19 of the present embodiment. In detail, FIG. 1 is a rough perspective view illustrating an example of a structure of the group 13 nitride crystal 19 of the present embodiment. FIG. 2 illustrates a view of a cross section parallel to the c-axis and a-axis in the group 13 nitride crystal 19. FIG. 3 is a cross sectional view of the c-plane cross section (cross section parallel to the c-plane) of the group 13 nitride crystal 19.

As illustrated in FIG. 3, the c-plane cross section of the group 13 nitride crystal 19 has a hexagonal shape. In the present embodiment, the hexagonal shape includes a regular hexagonal shape and hexagonal shapes other than the regular hexagonal shape. The side surfaces of the group 13 nitride crystal 19 that correspond to the sides of the hexagon are composed mainly of {10-10}m-planes of the hexagonal crystal structure.

In FIG. 1, the case where the group 13 nitride crystal 19 has a needle-like shape in which a hexagonal pyramid having a bottom surface formed by a c-plane (0001) and a central axis that is a c-axis (i.e., <0001> direction) is provided on a hexagonal columnar crystal having a bottom surface formed by a c-plane (0001) and the central axis formed by the c-axis is illustrated. Specifically, the case where the group 13 nitride crystal 19 is a needle-like crystal extending in the c-axis direction is illustrated. However, the group 13 nitride crystal 19 will do as long as it has a hexagonal crystal structure, and is not limited to having a needle-like shape. For example, it may also have a shape in which a c-plane is formed at the apex portion of the hexagonal pyramid of the group 13 nitride crystal 19 illustrated in FIG. 1.

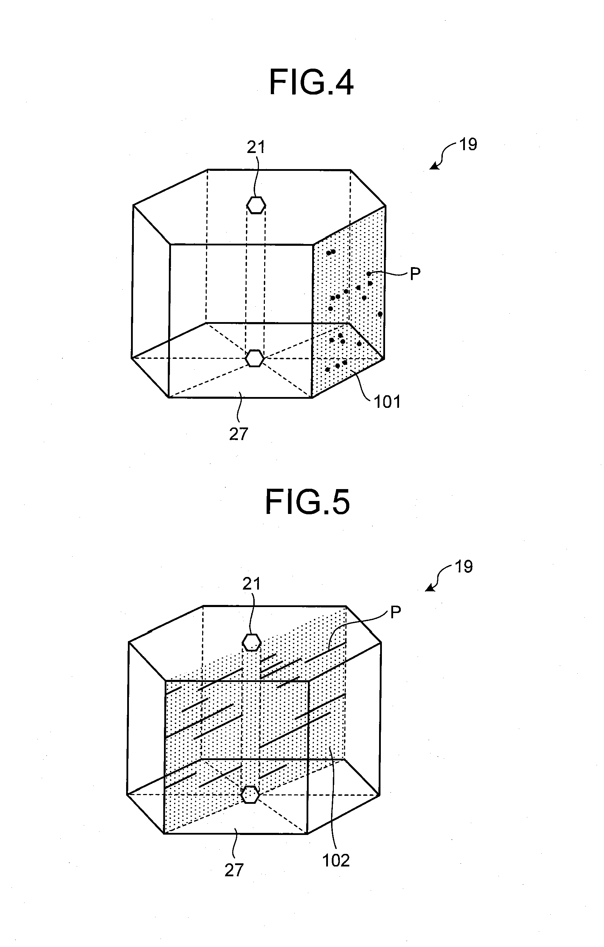

FIG. 4 and FIG. 5 are a schematic view illustrating an example of the group 13 nitride crystal 19 with a shape in which the c-plane is formed at the apex portion of the hexagonal pyramid. As illustrated in FIG. 4 and FIG. 5, the group 13 nitride crystal 19 has a hexagonal crystal structure, and may have a shape in which the c-plane is formed at the apex portion of the hexagonal pyramid of the group 13 nitride crystal 19 illustrated in FIG. 1.

Referring back to FIG. 1, the group 13 nitride crystal 19 in the present embodiment is a single crystal, but has a first region 21 and a second region 27. The first region 21 is a region disposed in the inner area of the c-plane cross section of the group 13 nitride crystal 19. The first region 21 is a seed crystal, and the second region 27 is a region crystal-grown from a seed crystal. The first region 21 and the second region 27 are a region different in crystal characteristics. Details of the first region 21 and the second region 27 will be described later. The group 13 nitride crystal 19 will do as long as it is a crystal containing the second region 27.

As described above, in the group 13 nitride crystal 19 of the present embodiment, the dislocation density of basal plane dislocations in a cross section parallel to the c-axis is 10⁴ cm⁻² or more. Here, in the group 13 nitride crystal 19 of the present embodiment, the dislocation density of basal plane dislocations in a cross section parallel to the c-axis is essentially 10⁴ cm⁻² or more and preferably less than 10¹⁰ cm⁻².

Specifically, in the group 13 nitride crystal 19, the dislocation density of basal plane dislocations in a cross section parallel to the c-axis includes 10⁵ cm⁻² or more, 10⁶ cm⁻² or more, and the order of 10⁹ cm⁻² or so.

When the dislocation density of basal plane dislocations in a cross section parallel to the c-axis includes 10⁴ cm⁻² or more, the crystal growth rate in the manufacture of the group 13 nitride crystal 19 can be made faster.

In addition, in the group 13 nitride crystal 19 of the present embodiment, it is preferred that the dislocation density of basal plane dislocations in a cross section parallel to the c-axis be higher than the dislocation density of threading dislocations of the c-plane in the cross section. The threading dislocation of the c-plane refers to a dislocation perpendicular to the c-plane (plane perpendicular to the c-axis). In the group 13 nitride crystal 19 of the present embodiment, the dislocation density of basal plane dislocations in a cross section parallel to the c-axis is preferably 100 times or more and further preferably 1000 times or more than the dislocation density of threading dislocations of the c-plane in the cross section.

In addition, in the group 13 nitride crystal 19, the dislocation density of threading dislocations in a cross section parallel to the c-axis is preferably 10³ cm⁻² or less and further preferably 10² cm⁻² or less.

In addition, the group 13 nitride crystal 19 may contain an inclusion.

Inclusion is a solidified matter of a molten mixture used to manufacture the group 13 nitride crystal 19 described later, and may be referred to as a flux. Inclusion is included in the crystal growth process in manufacturing the group 13 nitride crystal 19 (detail is described later).

The inclusion contains at least one of alkali metals, alkaline-earth metals and a mixture thereof, while it varies depending on the type of the used molten mixture. The alkali metals include at least one selected from sodium (Na), lithium (Li), and potassium (K). The alkali metal is preferably sodium (Na) or potassium (K). The alkaline-earth metals include at least one selected from calcium (Ca), magnesium (Mg), strontium (Sr), and barium (Ba). Hereinbelow, while the inclusion is described simply referred to as an alkali metal in some cases, it is needless to say that the other metals described above other than the alkali metal may be included.

FIG. 3 is a schematic view of the c-plane (c-plane cross section) of the group 13 nitride crystal 19.

For example, the c-plane cross section of the group 13 nitride crystal 19 is etched, and then observed with an electron microscope or by cathodoluminescence. Then, as illustrated in FIG. 3, a plurality of dislocations is observed. Among these dislocations observed in the c-plane cross section, a linear dislocation corresponds to a basal plane dislocation P. In addition, among the dislocations observed in the c-plane cross section, a point-like dislocation corresponds to a threading dislocation Q. In the case of cathodoluminescence, a dislocation is observed as a dark point or a dark line. Also, the c-plane cross section of the group 13 nitride crystal 19 contains inclusion I.

As illustrated in FIG. 3, the basal plane dislocation P in the group 13 nitride crystal 19 of the present embodiment contains a dislocation in the direction from the first region 21 as a seed crystal to the second region 27 as a crystal growth region. Specifically, as illustrated in FIG. 3, in the plane parallel to the c-plane, the basal plane dislocation P exists as a dislocation in the second region 27 that is a region crystal-grown from a seed crystal and in the direction to the crystal growth direction (outward).

In the group 13 nitride crystal 19 of the present embodiment, the dislocation density of basal plane dislocations in a cross section parallel to the c-axis and the dislocation density of threading dislocations of the c-plane are measured according to the following method.

For example, the outermost surface of the measurement object surface is etched or the like, thereby forming etch pits. Then, an image of the microstructure of the measurement object surface after etching is taken using an electron microscope, and the etch pit density is calculated from the obtained micrograph.

Also, the method of measuring the dislocation density includes a method of measuring the measurement object surface by cathodoluminescence (CL (electron beam fluorescence imaging)).

In the measurement object surface, the m-plane {10-10} is used as the cross section parallel to the c-axis in the present embodiment.

FIG. 4 is a schematic view illustrating the case where the side surfaces (m-plane {10-10}) of a hexagonal group 13 nitride crystal 19 are used as the measurement object surface.

As illustrated in FIG. 4, the m-plane {10-10} of the group 13 nitride crystal 19 is etched, and then a plurality of dislocations is observed with an electron microscope, or by cathodoluminescence. Among these dislocations observed in the m-plane {10-10}, a point-like dislocation is counted as basal plane dislocation P, thereby calculating the dislocation density of basal plane dislocations P. Here, a linear dislocation in the direction perpendicular to the c-axis is also counted as basal plane dislocation P. On the other hand, among the dislocations observed in the m-plane {10-10}, a linear dislocation extending in the c-axis direction can be taken as threading dislocation Q.

Here, regarding the point-like dislocation, one having the ratio of the major axis of the observed point-like dislocation to the minor axis of the point-like dislocation is 1 or more and 1.5 or less is counted as a "point-like" dislocation in the present embodiment. Therefore, not only a true circular dislocation, but also an elliptical dislocation is also counted as a point-like dislocation. More specifically, in the present embodiment, a dislocation with a major axis of 1 µm or less in the observed shape in the cross section is counted as a point-like dislocation.

On the other hand, regarding the linear dislocation, one having the ratio of the major axis of the observed linear dislocation to the minor axis of the observed linear dislocation is 4 or more is counted as a "linear" dislocation in the present embodiment. More specifically, in the present embodiment, a dislocation with a major axis exceeding 4 µm in the observed shape in the cross section is counted as a linear dislocation.

FIG. 5 is a schematic view when a cross section parallel to the c-axis and passing through the first region 21 as a seed crystal, as the cross section parallel to the c-axis, is used as the measurement object surface.

As illustrated in FIG. 5, a plurality of dislocations is observed with an electron microscope, or by cathodoluminescence after etching of the m-plane {10-10} of the group 13 nitride crystal 19. Among the dislocations observed in the m-plane {10-10} in FIG. 5, a linear dislocation extending in the direction parallel to the a-axis can be taken as basal plane dislocation P. On the other hand, a linear dislocation extending in the direction parallel to the c-axis direction can be taken as threading dislocation Q (not shown in FIG. 5). Here, the definitions of point-like dislocation and linear dislocation are the same as those described above.

Next, the first region 21 that is a seed crystal and the second region 27 that is a growth region grown from the seed crystal in the group 13 nitride crystal 19 will be described in detail.

The second region 27 is disposed so as to cover at least a part of the outer circumference of the first region 21 in the c-plane cross section of the group 13 nitride crystal 19. Here, the second region 27 will do so long as it is disposed so as to cover at least a part of the outer circumference of the first region 21, and may be disposed so as to cover all region of the outer circumference of the first region 21. FIG. 3 illustrates the group 13 nitride crystal 19 having a structure in which the second region 27 is disposed so as to cover all of the outer circumference of the first region 21.

The thickness of the second region 27 in the c-plane cross section is larger than the maximum diameter of the first region 21. The thickness of the second region 27 shows a maximum length of the second region 27, i.e., the maximum thickness, in the direction from the center of the first region 21 toward the outer edge of the group 13 nitride crystal 19. In the example illustrated in FIG. 3, the thickness of the second region 27 is illustrated as length L2.

The maximum diameter of the first region 21 refers to the maximum value of the diameter of the first region 21, and illustrated as length L1 in the example illustrated in FIG. 3.

Here, the relationship between the thickness of the second region 27 and the maximum diameter of the first region 21 in the c-plane cross section of the group 13 nitride crystal 19 of the present embodiment is not particularly limited so long as the above relationship is satisfied, and the thickness of the second region 27 based on the maximum diameter of the first region 21 is preferably 5 times or more, and further preferably 10 times or more.

Also, the carrier density of the second region 27 is higher than the carrier density of the first region 21. Here, in the group 13 nitride crystal 19 of the present embodiment, the relationship of the carrier density between the first region 21 and the second region 27 is not particularly limited so long as the above relationship is satisfied, and the carrier density of the second region 27 is preferably 5 times or more, and further preferably 10 times or more than the carrier density of the first region 21.

Moreover, the relationship of the carrier densities between the first region 21 and the second region 27 is not particularly limited so long as the above relationship is satisfied, and more specifically, the carrier density of the first region 21 is 2 × 10¹⁸/cm³ or less, and preferably 8 × 10¹⁷/cm³ or less. Also, the carrier density of the second region 27 is 4 × 10¹⁸/cm³ or more, and preferably 8 × 10¹⁸/cm³ or more.

Here, in the present embodiment, the carrier refers to an electron, and the carrier density refers to an electron carrier density.

The carrier densities of the first region 21 and the second region 27 are measured by the following measurement method.

The measurement of the carrier densities of the first region 21 and the second region 27 uses a method of converting the carrier density using raman spectroscopy. The conversion method of the carrier density uses "Characterization of GaN and Related Nitrides by Raman Scattering, Journal of the Spectroscopical Society of Japan 49 (2000): Hiroshi HARIMA". The carrier density is measured using a laser raman spectrometer as a measuring instrument.

Here, the carrier densities of the first region 21 and the second region 27 are adjusted so as to satisfy the above relationship by adjusting the manufacturing conditions in the method of manufacturing a group 13 nitride crystal 19 described later. In addition, the sizes (thickness and diameter) of the first region 21 and the second region 27 are also adjusted so as to satisfy the above relationship by adjusting the manufacturing conditions in the method of manufacturing a group 13 nitride crystal 19 described later.

### Manufacturing Method

Next, the method of manufacturing a group 13 nitride crystal 19 will be described.

The group 13 nitride crystal 19 is manufactured by growing a crystal from a seed crystal, using the seed crystal as the first region 21. Hereinafter, the seed crystal as the first region 21 is sometimes simply referred to as "seed crystal".

The seed crystal used to manufacture the group 13 nitride crystal 19 is a needle-like crystal which has a hexagonal crystal structure and elongated in the c-axis direction. Also, the cross section of the seed crystal perpendicular to the c-axis (c-plane cross section) has a hexagonal shape. In addition, the side surfaces of the seed crystal that correspond to the sides of the hexagon are composed mainly of m-planes of the hexagonal crystal structure.

### [2] Method of Manufacturing Crystal of Seed Crystal

### Crystal Manufacturing Apparatus

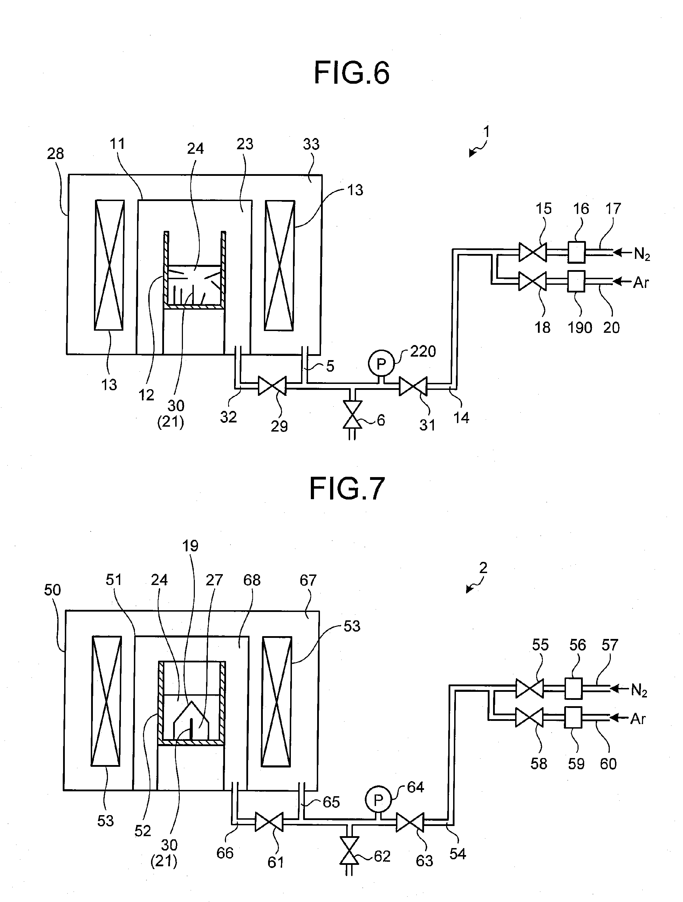

FIG. 6 is a rough cross sectional view of a crystal manufacturing apparatus 1 to manufacture a seed crystal. Hereinafter, the seed crystal used to manufacture the group 13 nitride crystal 19 is sometimes referred to as a seed crystal 30.

As illustrated in FIG. 6, the crystal manufacturing apparatus 1 comprises an outer pressure resistant vessel 28 made of stainless material. An inner container 11 is disposed in the outer pressure resistant vessel 28, and a reactor vessel 12 is further housed in the inner container 11. That is, the outer pressure resistant vessel 28 has a double structure. The inner vessel 11 is attachable to and detachable from the outer pressure resistant vessel 28.

A reactor vessel 12 is a vessel for retaining a molten mixture 24 obtained by melting source materials and additives to obtain the seed crystal 30.

In the outer pressure resistant vessel 28 and the inner vessel 11, a diluent gas supply tube 20 and a gas supply tube 32, that supply nitrogen (N₂) gas which is a source of the group 13 nitride crystal and a diluent gas for controlling the total pressure, are respectively connected to an inner space 33 of the outer pressure resistant vessel 28 and an inner space 23 of the inner vessel 11. A gas supply tube 14 divides into a nitrogen supply tube 17 and a diluent gas supply tube 20, and the tubes 17 and 20 are configured to be separable at a valve 15 and a valve 18, respectively.

It is desirable to use argon (Ar) gas which is an inert gas as the diluent gas but is not limited thereto, and other inert gas such as helium (He) may be used as the diluent gas.

The nitrogen gas is supplied from the nitrogen supply tube 17 which is connected to a gas cylinder or the like containing the nitrogen gas, subjected to a pressure control by a pressure regulator 16 and then supplied to the gas supply tube 14 via the valve 15. On the other hand, the diluent gas (e.g. argon gas) is supplied from the diluent gas supply tube 20 which is connected to a gas cylinder or the like containing the diluent gas, subjected to a pressure control by a pressure regulator 190 and then supplied to the gas supply tube 14 via the valve 18. The nitrogen gas and the diluent gas, pressures of which are controlled in this way, are supplied to the gas supply tube 14 and are mixed.

Then, the gas mixture of the nitrogen gas and the diluent gas is supplied to the outer pressure resistant vessel 28 and the inner vessel 11 from the gas supply tube 14 via a valve 31 and a valve 29. Here, the inner vessel 11 can be removed from the crystal manufacturing apparatus 1 at the valve 29.

A pressure meter 220 is provided at the gas supply tube 14, and the pressures inside of the outer pressure resistant vessel 28 and inner vessel 11 can be controlled while monitoring the total pressure inside of the outer pressure resistant vessel 28 and the inner vessel 11 with the pressure meter 220.

In the crystal manufacturing apparatus 1 of the present embodiment, the partial pressure of nitrogen can be controlled by controlling the pressures of the nitrogen gas and the diluent gas by means of the valve 15 and the valve 18 and by means of the pressure regulator 16 and a pressure regulator 190. Also, since the total pressure of the outer pressure resistant vessel 28 and the inner vessel 11 can be controlled, it is possible to reduce evaporation of alkali metal (e.g. sodium) in the reactor vessel 12 by increasing the total pressure inside of the inner vessel 11. In other words, it is possible to separately control the partial pressure of nitrogen which becomes a nitrogen source affecting the crystal growth conditions of gallium nitride and the total pressure affecting the reduction of sodium evaporation.

Also, as illustrated in FIG. 6, a heater 13 is disposed around the outer circumference of the inner vessel 11 inside of the outer pressure resistant vessel 28, thus the inner vessel 11 and the reactor vessel 12 can be heated to control the temperature of the molten mixture 24.

In the present embodiment, the seed crystal 30 is manufactured by a flux method.

A method of manufacturing the seed crystal 30 includes, for example, a boron melting process in which boron is melted into the molten mixture 24, a boron taking process in which boron is taken into the crystal while the gallium nitride crystal 25 is grown, and a boron reducing process in which the boron density in the molten mixture 24 is reduced as the crystal grows. Here, the boron reducing process may be omitted.

In the boron melting process, the boron is melted into the molten mixture 24 from boron nitride (BN) contained in the inner wall of the reactor vessel 12 or from a boron nitride component disposed inside of the reactor vessel 12. Then, the melted boron is taken into the crystal while the crystal grows (the boron taking process). Moreover, an amount of boron taken into the crystal is gradually reduced as the crystal grows (the boron reducing process).

According to the boron reducing process, it is possible to reduce the boron density of the outer region in a cross section intersecting the c-axis in comparison with the boron density of the inner region in the cross section, while the seed crystal 30 crystal-grows with growing the m-planes ({10-10} planes). Thereby, the density of boron as impurities can be reduced and the dislocation density in the crystal which may be induced by the impurities can be reduced, at the outer peripheral face composed of the m-planes (six side surfaces of the hexagonal column) of the seed crystal 30. Thus, the outer circumferential surface of the seed crystal 30 can be made of the higher quality crystal in comparison with the inner region.

Next, the boron melting process, the boron taking process and the boron reducing process will be more specifically described.

### (1) Method with Reactor Vessel 12 Containing Boron Nitride

As an example of the boron melting process, a reactor vessel 12 made of a sintered boron nitride (sintered BN) can be used as the reactor vessel 12. In the course of heating the reactor vessel 12 to a crystal growth temperature, boron is melted from the reactor vessel 12 into the molten mixture 24 (the boron melting process). Then, the boron in the molten mixture 24 is taken into the seed crystal 30 in the course of growing the seed crystal 30 (the boron taking process). The boron in the molten mixture 24 is gradually reduced as the seed crystal 30 grows (the boron reducing process).

In the above example, the reactor vessel 12 made of the sintered BN is used, but the constitution of the reactor vessel 12 is not limited thereto. In a preferable embodiment, in the reactor vessel 12, it is sufficient that a boron nitride-containing material (e.g. sintered BN) is used at least at a part of its inner wall coming into contact with the molten mixture 24. In the other part of the reactor vessel 12, nitrides such as pyrolytic BN (P-BN), oxides such as alumina and YAG, carbides such as SiC and the like can be used.

### (2) Method with Boron Nitride-Containing Component Placed in Reactor Vessel 12

Furthermore, as another example of the boron melting process, a boron nitride-containing component may be disposed in the reactor vessel 12. As an example, a component of the sintered BN may be placed in the reactor vessel 12. Materials of the reactor vessel 12 are not particularly limited, as in (1).

In this method, in the course of heating the reactor vessel 12 to the above crystal growth temperature, the boron is gradually melted into the molten mixture 24 from the component disposed inside of the reactor vessel 12 (the boron melting process).

In the methods (1) and (2), crystal nuclei of nitride gallium crystal are likely to be formed on a surface of the boron nitride-containing component coming into contact with the molten mixture 24. Therefore, if the surface of the boron nitride (i.e. the inner wall surface or the component surface described above) is gradually covered with the formed gallium nitride crystal nuclei, the amount of boron melted from the covered boron nitride into the molten mixture 24 gradually decreases (the boron reducing process). Furthermore, in accordance with the growth of the gallium nitride crystal, a surface area of the crystal increases, thus the density of boron which is taken into the gallium nitride crystal decreases (the boron reducing process).

In the (1) and (2) described above, the boron is melted into the molten mixture 24 using a boron-containing material, but a method of melting the boron into the molten mixture 24 is not limited thereto. Any other method such that, the boron is added into the molten mixture 24, may be used. Also, as for a method of reducing the boron density in the molten mixture 24, any other method may be used. The crystal manufacturing process of the present embodiment will do as long as it includes at least the boron melting process, the boron taking process and the boron reducing process described above.

Adjustment of Source Materials or the Like and Crystal Growth Conditions

An operation to put the source material or the like into the reactor vessel 12 is conducted in such a manner that the inner vessel 11 is put into a glove box under an inert gas atmosphere such as argon gas.

In a case that the seed crystal 30 is grown by the method (1), the boron-containing material as described above in (1), a material used as a flux, and source materials are put into the reactor vessel 12 having such a constitution as described above in (1).

In a case that the seed crystal 30 is grown by the method (2), the boron nitride-containing component as described above in (2), a material used as a flux and source materials are put into the reactor vessel 12 having such a constitution as described above in (2).

The material used as a flux may be sodium, or sodium compound (e.g. sodium azide) as described above as the inclusion I. Any other material including other alkali metals such as lithium and potassium, or compounds of these alkali metals may also be used. In addition, alkaline-earth metals such as barium, strontium and magnesium, or compounds of these alkaline-earth metals may be also used. Here, plural kinds of alkali metals or alkaline-earth metals may be also used.

As the source material, gallium is used, and other materials including other group 13 elements such as boron, aluminum and indium, or mixtures thereof may be used as source materials to be put into the reactor vessel 12.

Also, in the present embodiment, while the reactor vessel 12 having a constitution containing boron is described, it is not limited only to a constitution containing boron and the reactor vessel 12 may have a constitution containing at least one of B, Al, O, Ti, Cu, Zn and Si.

After setting the source materials or the like as described above, the inner vessel 11 and the reactor vessel 12 inside the inner vessel 11 are heated to a crystal growth temperature by turning on the heater 13. Then, the source material or the like is melted along with the material used as the flux in the reactor vessel 12 to form the molten mixture 24. Also, nitrogen as the source of the seed crystal 30 can be supplied to the molten mixture 24 by bringing the nitrogen having the above-described partial pressure into contact with the molten mixture 24 and thereby dissolving the nitrogen into the molten mixture 24. Furthermore, boron is melted into the molten mixture 24 as described above (the boron melting process) (the molten mixture forming step).

Moreover, crystal nuclei of the seed crystal 30 are formed on the inner wall of the reactor vessel 12 from source materials and boron that are melted in the molten mixture 24. Then, the source materials and boron in the molten mixture 24 are supplied to these crystal nuclei, thereby growing the crystal nuclei to the needle-like seed crystal 30. In the course of the crystal growth of the seed crystal 30, boron in the molten mixture 24 is taken into the crystal (the boron taking process), as described above. Thus, the boron-rich region is likely to be formed in the inner part of the seed crystal 30, and the seed crystal 30 is likely to be elongated in the c-axis direction. Also, as the boron density in the molten mixture 24 reduces, the amount of boron taken into the crystal reduces (the boron reducing process). Then, the boron-poor region is likely to be formed on the outside of the region, and the seed crystal 30 is likely to grow toward the m-axis directions while the growth toward the c-axis direction slows.

Here, the partial pressure of nitrogen in the inner vessel 11 is preferably in the range of 5 MPa to 10 MPa.

Also, the temperature (crystal growth temperature) in the molten mixture 24 is preferably in the range of 800°C to 900°C.

As a preferable embodiment, it is preferred that the ratio of the mol number of the alkali metal to the total mol number of gallium and the alkali metal (e.g. sodium) be in the range of 75% to 90%, the crystal growth temperature of the molten mixture 24 be in the range of 860°C to 900°C, and the partial pressure of nitrogen be in the range of 5 MPa to 8 MPa.

As a further preferable embodiment, it is more preferred that the molar ratio of gallium and the alkali metal be 0.25 : 0.75, the crystal growth temperature be in the range of 860°C to 870°C, and the partial pressure of nitrogen be in the range of 7 MPa to 8 MPa.

Via the above-described processes, there is obtained the seed crystal 30 which is to be used to manufacture the group 13 nitride crystal 19.

### [3] Method of Manufacturing Group 13 Nitride Crystal

The group 13 nitride crystal 19 described above is manufactured by using the seed crystal 30 described above in [2], and enlarging the c-plane cross sectional area of these seed crystals 30 by a flux method.

### Crystal Manufacturing Apparatus

FIG. 7 is a rough cross sectional view illustrating a constitution example of a crystal manufacturing apparatus 2 used for manufacturing the group 13 nitride crystal 19 by growing a crystal of the second region 27 from the seed crystal 30. In the crystal manufacturing apparatus 2, an inner vessel 51 is disposed in an outer pressure resistant vessel 50 made of stainless material. A reactor vessel 52 is further housed in the inner vessel 51, thus the crystal manufacturing apparatus 2 has a double structure. The inner vessel 51 is attachable to and detachable from the outer pressure resistant vessel 50.

The reactor vessel 52 is a vessel for retaining the seed crystal 30 and a molten mixture 24 containing an alkali metal and a material containing at least a group 13 element to perform crystal growth of the second region 27 from the seed crystal 30 (the growth of a bulk crystal based on a seed crystal is referred to as SG: Seed Growth)).

The material of the reactor vessel 52 is not particularly limited, and nitrides such as sintered BN and P-BN, oxides such as alumina and YAG, carbides such as SiC and the like can be used. Also, desirably, the inner wall surface of the reactor vessel 52, i.e., a portion of the reactor vessel 52 that comes into contact with the molten mixture 24, is formed of a material less likely to react with the molten mixture 24. When the second region 27 is formed by a gallium nitride crystal, examples of the material that allows crystal growth of gallium nitride include nitrides such as boron nitride (BN), pyrolytic BN (P-BN) and aluminum nitride, oxides such as alumina and yttrium-aluminum-garnet (YAG) and stainless steel (SUS), and the like.

Moreover, in the outer pressure resistant vessel 50 and the inner vessel 51, a gas supply tube 65 and a gas supply tube 66, that supply nitrogen (N₂) gas which is a source of the group 13 nitride crystal 19 and a diluent gas for controlling the total pressure, are respectively connected to an inner space 67 of the outer pressure resistant vessel 50 and an inner space 68 of the inner vessel 51. A gas supply tube 54 divides into a nitrogen supply tube 57 and a gas supply tube 60, and the tubes 57 and 60 is configured to be separable at a valve 55 and a valve 58, respectively.

It is desirable to use argon (Ar) gas which is an inert gas as the diluent gas but is not limited thereto, and other inert gas such as helium (He) may be used as the diluent gas.

The nitrogen gas is supplied from the nitrogen supply tube 57 which is connected to a gas cylinder or the like containing the nitrogen gas, subjected to a pressure control by a pressure regulator 56 and then supplied to the gas supply tube 54 via the valve 55. On the other hand, the gas for controlling the total pressure (e.g. argon gas) is supplied from the gas supply tube 60 which is connected to a gas cylinder or the like containing the gas for controlling the total pressure, subjected to a pressure control by a pressure regulator 59 and then supplied to the gas supply tube 54 via the valve 58. The nitrogen gas and the gas for controlling the total pressure, pressures of which are controlled in this way, are supplied to the gas supply tube 54 and are mixed.

Then, the gas mixture of the nitrogen gas and the diluent gas is supplied to the outer pressure resistant vessel 50 and the inner vessel 51 from the gas supply tube 54 via a valve 63, the gas supply tube 65, a valve 61 and the gas supply tube 66. Here, the inner vessel 51 can be removed from the crystal manufacturing apparatus 2 at the valve 61. Also, the gas supply tube 65 is connected to the outside via a valve 62.

Moreover, a pressure meter 64 is provided at the gas supply tube 54, and the pressures inside of the outer pressure resistant vessel 50 and inner vessel 51 can be controlled while monitoring the total pressure inside of the outer pressure resistant vessel 50 and the inner vessel 51 with the pressure meter 64.

In the present embodiment, the partial pressure of nitrogen can be controlled by controlling the pressures of the nitrogen gas and the diluent gas by means of the valve 55 and the valve 58 and by means of the pressure regulator 56 and a pressure regulator 59. Also, since the total pressure of the outer pressure resistant vessel 50 and the inner vessel 51 can be controlled, it is possible to reduce evaporation of alkali metal (e.g. sodium) in the reactor vessel 52 by increasing the total pressure inside of the inner vessel 51. In other words, it is possible to separately control the partial pressure of nitrogen which becomes a nitrogen source affecting the crystal growth conditions of gallium nitride and the total pressure affecting the reduction of sodium evaporation.

Also, as illustrated in FIG. 7, a heater 53 is disposed around the outer circumference of the inner vessel 51 inside of the outer pressure resistant vessel 50, thus the inner vessel 51 and the reactor vessel 52 can be heated to control the temperature of the molten mixture 24.

Adjustment of Source Materials or the Like and Crystal Growth Conditions

An operation to put the source material such as the seed crystal 30, additives such as Ga, Na and C and a dopant such as Ge and the like into the reactor vessel 52 is conducted in such a manner that the inner vessel 51 is put into a glove box under an inert gas atmosphere such as argon gas. This operation may be performed with the reactor vessel 52 being placed in the inner vessel 51.

The seed crystal 30 described above in [2] is disposed in the reactor vessel 52. Also, a material containing at least a group 13 element (for example, gallium) and a material used as the flux described above are placed in the reactor vessel 52. In the present embodiment, an alkali metal is used as the flux.

For example, gallium that is a group 13 element is used as the material containing a group 13 element as the source material. As other examples, other group 13 elements such as boron, aluminum and indium and any mixture thereof may also be used.

The molar ratio of the material containing a group 13 element to the alkali metal is not particularly limited, and the molar ratio of the alkali metal to the total mol number of the group 13 element and the alkali metal is preferably 40% to 95%.

After setting the source materials or the like as described above, the inner vessel 51 and the reactor vessel 52 inside the inner vessel 51 are heated to a crystal growth temperature by turning on the heater 53. Then, the material containing a group 13 element as the source material, the alkali metal, other additives and the like are melted in the reactor vessel 52 to form the molten mixture 24. Also, nitrogen as the source of the group 13 nitride crystal 19 can be supplied to the molten mixture 24 by bringing the nitrogen having the above-described partial pressure into contact with the molten mixture 24 and thereby dissolving the nitrogen into the molten mixture 24 (the molten mixture forming step).

Then, the source materials dissolved in the molten mixture 24 are supplied to the outer peripheral surface of the seed crystal 30, and the second region 27 is crystal-grown from the outer peripheral surface of the seed crystal 30 by the source materials (crystal growth process).

In this way, the second region 27 is crystal-grown from the outer peripheral face of the seed crystal 30, whereby the group 13 nitride crystal 19 containing the seed crystal 30 can be manufactured.

Here, in the method of manufacturing the group 13 nitride crystal 19 of the present embodiment, the crystal growth rate in the a-axis direction of the seed crystal 30 when the seed crystal 30 is crystal-grown is higher than 15 µm/hr.

The crystal growth conditions are adjusted so that the crystal growth rate in the a-axis direction of the seed crystal 30 is higher than 15 µm/hr, whereby the group 13 nitride crystal 19 of the present embodiment having a dislocation density of basal plane dislocations in a cross section parallel to the c-axis of 10⁴ cm⁻² or more can be manufactured.

Here, the crystal growth rate in the a-axis direction of the seed crystal 30 when the seed crystal 30 is crystal-grown is essentially higher than 15 µm/hr, and preferably 18 µm/hr or more, further preferably 23 µm/hr or more, and particularly preferably 28 µm/hr or more.

The crystal growth rate in the a-axis direction of the seed crystal 30 is adjusted to 18 µm/hr or more, whereby the group 13 nitride crystal 19 having a dislocation density of basal plane dislocations in a cross section parallel to the c-axis exceeding 10⁴ cm⁻² can be manufactured. The crystal growth rate in the a-axis direction of the seed crystal 30 is adjusted to 23 µm/hr or more, whereby a dislocation density of basal plane dislocations in a cross section parallel to the c-axis of the group 13 nitride crystal 19 can be adjusted to 10⁵ cm⁻² or more.

Also, the crystal growth rate in the a-axis direction of the seed crystal 30 is adjusted to 28 µm/hr or more, whereby a dislocation density of basal plane dislocations in a cross section parallel to the c-axis of the group 13 nitride crystal 19 can be adjusted to 10⁶ cm⁻² or more.

The growth rate when the seed crystal 30 is crystal-grown is adjusted by adjusting the partial pressure of nitrogen and the crystal growth temperature.

Specifically, in order to adjust the crystal growth rate in the a-axis direction of the seed crystal 30 to higher than 15 µm/hr, the partial pressure of the nitrogen gas in the inner space 68 of the inner vessel 51 and in the inner space 67 of the outer pressure resistant vessel 50 is at least adjusted to the range of 2.0 MPa or more and 4.6 MPa or less, and the temperature (crystal growth temperature) in the molten mixture 24 is adjusted in the range of 840°C or more and 890°C or less.

In addition, in order to adjust the crystal growth rate in the a-axis direction of the seed crystal 30 to 18 µm/hr or more, the partial pressure of the nitrogen gas in the inner space 68 of the inner vessel 51 and in the inner space 67 of the outer pressure resistant vessel 50 is at least adjusted to the range of 2.0 MPa or more and 3.8 MPa or less, and the temperature (crystal growth temperature) in the molten mixture 24 is adjusted in the range of 840°C or more and 880°C or less.

Moreover, in order to adjust the crystal growth rate in the a-axis direction of the seed crystal 30 to 23 µm/hr or more, the partial pressure of the nitrogen gas in the inner space 68 of the inner vessel 51 and in the inner space 67 of the outer pressure resistant vessel 50 is at least adjusted to the range of 2.0 MPa or more and 3.2 MPa or less, and the temperature (crystal growth temperature) in the molten mixture 24 is adjusted in the range of 840°C or more and 870°C or less.

Also, in order to adjust the crystal growth rate in the a-axis direction of the seed crystal 30 to 28 µm/hr or more, the partial pressure of the nitrogen gas in the inner space 68 of the inner vessel 51 and in the inner space 67 of the outer pressure resistant vessel 50 is at least adjusted to the range of 2.0 MPa or more and 2.8 MPa or less, and the temperature (crystal growth temperature) in the molten mixture 24 is adjusted in the range of 840°C or more and 860°C or less.

Like this, in the group 13 nitride crystal 19 of the present embodiment, the crystal growth rate in the a-axis direction of the seed crystal 30 when the group 13 nitride crystal 19 is prepared is higher than 15 µm/hr. Thus, the group 13 nitride crystal 19 of the present embodiment can shorten the manufacturing time.

Therefore, in the group 13 nitride crystal 19 of the present embodiment, the group 13 nitride crystal 19 used in a substrate suitable for manufacturing a semiconductor device can be manufactured.

In addition, in the present embodiment, the seed crystal 30 used to manufacture the group 13 nitride crystal 19 is a needle-like crystal manufactured by growing mainly in the c-axis direction. On the other hand, the group 13 nitride crystal 19 manufactured by crystal-growing the second region 27 from the seed crystal 30 is manufactured by crystal-growing mainly in the direction perpendicular to the c-axis. Therefore, the first region 21 as the seed crystal 30 and the second region 27 that is the crystal growth region are different in the crystal growth direction. When the crystal growth direction is different, impurities are differently taken in, thus the first region 21 and the second region 27 become the regions in which impurities are differently taken in. Therefore, it is considered that the second region 27 obtained by crystal-growing in the direction perpendicular to the c-axis according to the above manufacturing method becomes a region having a higher carrier density in comparison with the first region 21 obtained by crystal growth in the c-axis direction.

Also, in the manufactured group 13 nitride crystal 19, the second region 27 as the crystal growth region has a larger thickness in comparison with the maximum diameter of the first region 21 as the seed crystal 30 in the c-plane cross section. Therefore, it is considered that a group 13 nitride crystal 19 preferably applicable to further low resistivity semiconductor devices or the like can be obtained by using this second region 27.

Here, in the present embodiment, the group 13 nitride crystal 19 prepared according to the above manufacturing method grows from the m-planes that are the outer peripheral surface of the seed crystal 30 in the m-axis directions (i.e., the directions in which the size of a hexagonal c-plane cross section increases). Thus, a dislocation is likely to be caused in the direction along the crystal growth direction in the second region 27 when a crystal is grown from the seed crystal 30.

Therefore, a number of basal plane dislocations P of the group 13 nitride crystal 19 are generated in the direction along the crystal growth direction.

Also, when a crystal is grown, the crystal is grown with also taking in an alkali metal or the like used as a flux (molten mixture). It is considered that dislocations such as point defect and line defect are generated while a crystal is grown from the seed crystal 30, and the flux such as alkali metal or the like enters a space due to these defects. Therefore, as described using FIG. 3, the inclusion I that is a solidified matter of a molten mixture is generated in the second region 27 of the group 13 nitride crystal 19. Here, the defect generated in the second region 27 when a crystal is grown is likely to be caused in the direction along the crystal growth direction, as described above. Therefore, the inclusion I is also included in the group 13 nitride crystal 19 in the form extending in the direction from the first region 21 that is the seed crystal 30 to the second region 27.

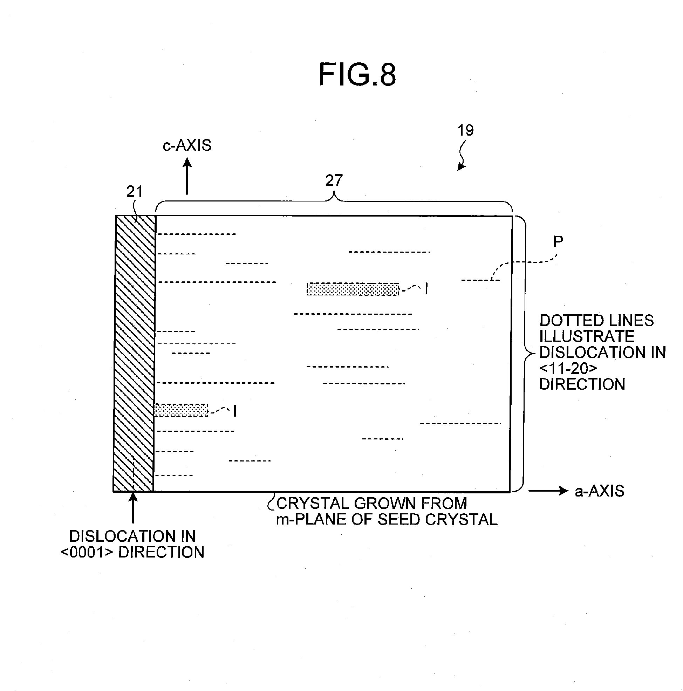

FIG. 8 is a diagram schematically illustrating dislocations in a cross section parallel to the c-axis and an a-axis in the group 13 nitride crystal 19. Here, FIG. 8 is an enlarged illustration of a part of the cross section parallel to the c-axis and a-axis of the group 13 nitride crystal 19.

Generally, even when a crystal is grown by any of the flux method, the HVPE method or the like, more than a few dislocations are generated in the group 13 nitride crystal 19. Also, when dislocations (line defects, point defects) are present on the outer peripheral surface of the first region 21, these dislocations may also propagate into the second region 27 when the second region 27 is crystal-grown from the outer peripheral surface of the seed crystal 30 in the region (first region 21). It is considered that the causes of the occurrence of dislocations are the differences in thermal expansion coefficient and lattice constant between the seed crystal 30 (first region 21) and the second region 27 grown from the seed crystal 30 (first region 21), and crystal strain and defects such as cracks on the surfaces of the seed crystal.

Generally, dislocations (line defects) extending parallel to the direction of crystal growth continue to extend without disappearance during crystal growth. On the other hand, line defects extending in directions not parallel to the direction of crystal growth often disappear during crystal growth. More specifically, a crystal is grown from the m-planes that are the outer peripheral surface composed on the m-planes of the seed crystal 30 in the m-axis directions (i.e., the directions in which the size of a hexagonal c-plane cross section increases (crystal growth direction)). Therefore, the number of dislocations generated from the growth boundary of the seed crystal 30 (first region 21) is large in <11-20> directions parallel to the directions of crystal growth and is small in <11-23> directions not parallel to the directions of crystal growth.

Thus, in the group 13 nitride crystal 19 of the present embodiment, the number of threading dislocations that penetrates the c-plane (threading dislocations Q) is smaller, in comparison with the number of basal plane dislocations that is a dislocation parallel to the c-plane (basal plane dislocations P). That the number of basal plane dislocations is more than the number of threading dislocations means that the group 13 nitride crystal 19 has been manufactured by crystal growth in the directions in which the size of a c-plane cross section increases.

In addition, as illustrated in FIG. 8, the inclusion I is included in the group 13 nitride crystal 19 in the form extending in the direction from the first region 21 that is the seed crystal 30 to the second region 27. Thus, the included inclusion is likely to be ejected in the m-axis directions from inside to outside of the group 13 nitride crystal 19 by heat treatment or the like described later. Therefore, the group 13 nitride crystal 19 suitable for a semiconductor device can be further preferably provided.

Here, in the crystal manufacturing method of the present embodiment, it is possible to use the same material (for example, gallium nitride) for the seed crystal 30 and the second region 27 grown from the seed crystal 30. In this case, unlike the case where a seed crystal of a different material such as aluminum nitride (AlN) is used, lattice constant and thermal expansion coefficient can be conformed, and it is possible to suppress generation of dislocation due to lattice mismatch and the difference in thermal expansion coefficient.

Furthermore, since the seed crystal 30 (first region 21) and the second region 27 are manufactured in the same crystal growth method (flux method), it is possible to improve consistency of lattice constant and thermal expansion coefficient, and dislocation generation can be easily suppressed, as compared to the case where the seed crystal 30 and the second region 27 are manufactured by different methods from each other.

Via the above-described processes, the group 13 nitride crystal 19 suitable for a semiconductor device can be manufactured.

While the crystal manufacturing method by a flux method is described above, the crystal manufacturing method is not particularly limited, and crystal growth may be performed by vapor deposition such as an HVPE method or a liquid phase method other than the flux method. From the viewpoint of manufacturing a high-quality group 13 nitride crystal 19, the flux method is preferably used.

In the group 13 nitride crystal 19 manufactured by the manufacturing method described above in [3], the position of the first region 21 that is a region used as the seed crystal 30 will do as long as it is the inside of the group 13 nitride crystal 19, may be a position that penetrates the center of the c-plane cross section of the group 13 nitride crystal 19 along the c-axis direction, and may be a position shifted from the position that penetrates the center along the c-axis direction.

Also, in the present embodiment, the case where the group 13 nitride crystal 19 is a needle-like crystal in which, on a hexagonal columnar crystal, a hexagonal pyramid having a bottom surface formed by the upper base of the hexagonal column is provided is described, but is not limited to this shape. For example, the group 13 nitride crystal 19 may be a hexagonal pyramid in which the m-plane is not formed.

Here, in the method of manufacturing the group 13 nitride crystal 19 of the present embodiment, it is preferred that a heat treatment process be further included. This heat treatment process may be performed after manufacturing the group 13 nitride crystal 19, and may be performed before processing into the group 13 nitride crystal substrate described later, or after processing into a substrate.

In the heat treatment process in the present embodiment, the inclusion I such as alkali metal included in the group 13 nitride crystal 19 is discharged in the direction perpendicular to the c-axis by applying heat to the group 13 nitride crystal 19. More specifically, as described above, the inclusion I is included in the group 13 nitride crystal 19 in the form extending in the direction from the first region 21 that is the seed crystal 30 to the second region 27. Therefore, in the present embodiment, the inclusion I included in the group 13 nitride crystal 19 is ejected (discharged) in the direction perpendicular to the c-axis by heat treatment.

The heat treatment temperature in the heat-treatment process will do as long as it is the boiling point of the inclusion I or more. Specifically, the heat treatment temperature is 883°C or more. At the higher temperature the group 13 nitride crystal 19 is heat-treated, the inclusion I is likely to be efficiently ejected. Thus, the heat treatment temperature is preferably 1000°C or more, further preferably 1100°C or more, and particularly preferably 1200°C or more.

In addition, the heat treatment process is preferably performed under a nitrogen atmosphere or under an atmosphere of a mixed gas of nitrogen and ammonia, from the viewpoint of suppressing the decomposition of the group 13 nitride at the surface of the group 13 nitride crystal 19.

As described above, in the group 13 nitride crystal 19 of the present embodiment, dislocations are generated with a dislocation density of the basal plane dislocations P in the cross section parallel to the c-axis of 10⁴ cm⁻² or more. Here, the basal plane dislocation P is a dislocation in the direction parallel to the c-plane direction as described above. Also, as described above, in the group 13 nitride crystal 19, dislocations in the direction from the first region 21 that is the seed crystal 30 to the second region 27 are much generated through the above manufacturing process. In addition, along these dislocations, inclusion I is included in the group 13 nitride crystal 19 in the form extending in the direction from the first region 21 that is the seed crystal 30 to the second region 27.

Therefore, when the group 13 nitride crystal 19 is heated to the temperature exceeding the boiling point of inclusion I (solidified matter of a molten mixture (alkali metal or the like)), inclusion I spreads to the m-plane of the group 13 nitride crystal 19 along the distribution of defects in the group 13 nitride crystal 19, and is discharged mainly in the direction perpendicular to the c-axis from the outer peripheral face of the group 13 nitride crystal 19.

Therefore, in the group 13 nitride crystal 19 in the present embodiment, inclusion can be preferably removed.

### [4] Group 13 Nitride Crystal Substrate

The group 13 nitride crystal substrate in the present embodiment is obtained by processing the group 13 nitride crystal 19.

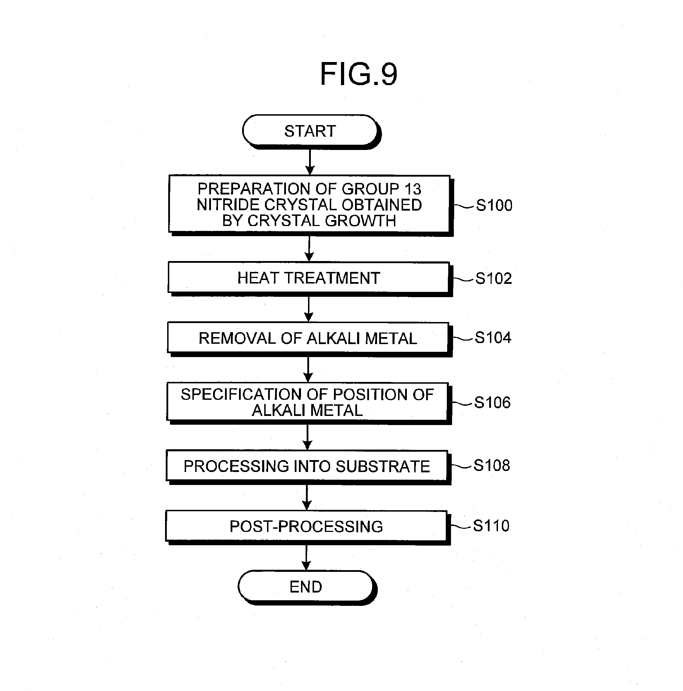

FIG. 9 is a process chart illustrating a method of manufacturing a group 13 nitride crystal substrate from the group 13 nitride crystal 19 before performing heat treatment process described above.

As illustrated in FIG. 9, first, the group 13 nitride crystal 19 manufactured by crystal-growing the second region 27 from the seed crystal 30 (first region 21) is prepared (Step S100). Next, this group 13 nitride crystal 19 is subjected to heat treatment (heat treatment process) (Step S102). This heat treatment process is the same as described above.

Next, inclusion I such as alkali metal or the like discharged from the group 13 nitride crystal 19 is removed (Step S104). In Step S104, for example, the group 13 nitride crystal 19 is washed with an acid solution, thereby removing inclusion I on the surface of the group 13 nitride crystal 19. As the acid solution, a hydrofluoric acid solution, a buffered hydrofluoric acid solution, a hydrochloric acid solution, a sulfuric acid solution, a nitric acid solution, a sulfuric peroxide solution, a mixed solution thereof or the like can be used.

In Step S104, specifically, it is preferred that a series of treatments in which the group 13 nitride crystal after heat treatment is immersed in a 20% hydrochloric acid solution diluted with pure water (hydrochloric acid solution : pure water = 1 : 4) for 60 minutes and then subjected to ultrasonic cleaning in pure water for 10 minutes be repeated 3 times or more.

Next, the position of inclusion I (for example, position of alkali metal) included in the group 13 nitride crystal 19 is specified (Step S106).

The position of inclusion I is specified, for example, by the following method. When the crystalline form of the target, inclusion I of which is to be specified, is a bulk form, the position of the inclusion I can be specified by measurement using an X-ray computed tomography scanner or transmission x-ray observation device. When the crystalline form of the specific subject is a substrate-form, the position of the inclusion I can be specified by, in addition to the observation utilizing X-ray described above, observation using an optical microscope. Among microscopes, a microscope having high spatial resolution like a confocal laser scanning microscope is used, whereby the position of the inclusion I can be more accurately captured.

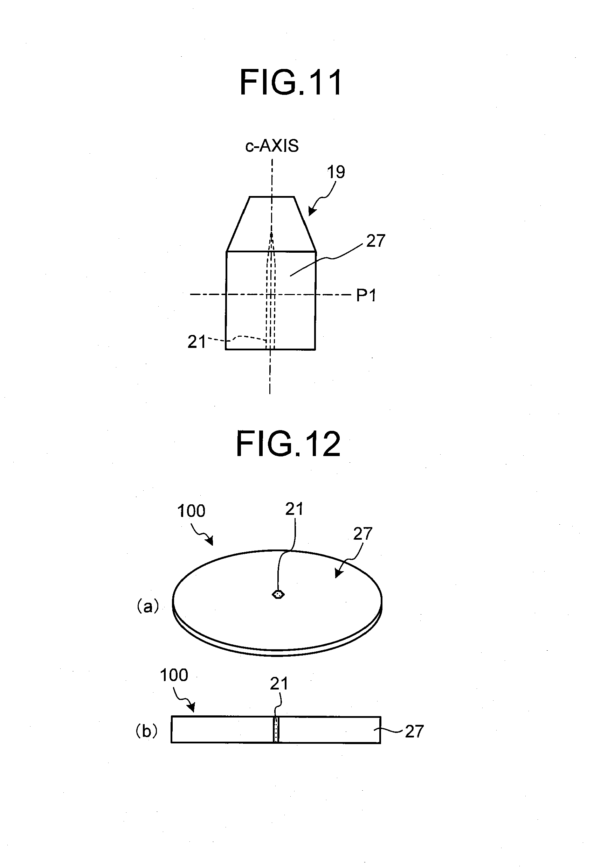

Next, the resulting crystal is processed into a substrate (Step S108). Specifically, the group 13 nitride crystal 19 is cut so that the group 13 nitride crystal substrate having a principal surface formed by the c-plane is made, so as not to include alkali metal (inclusion I) within 10 µm from the surface (see dotted line P1 in FIG. 11).

The group 13 nitride crystal substrate of the present embodiment having a principal surface formed by the c-plane has a small number of threading dislocations in the direction that penetrates the surface of the c-plane as described above, thus is preferably used for manufacturing a semiconductor device.

As described above, the group 13 nitride crystal is cut with adjusting the cutting position so as not to contain the inclusion I after specifying the position of the inclusion I, whereby the group 13 nitride crystal substrate can be efficiently manufactured.

As a method of cutting (slicing) the group 13 nitride crystal, there are a method of obtaining a plurality of group 13 nitride crystal substrates at a time using a multi-wire saw or the like and a method of obtaining a group 13 nitride crystal substrate one by one with a blade saw (outer peripheral cutting edge, inner peripheral cutting edge, or the like). When processing with a multi-wire saw, the position of the retained group 13 nitride crystal 19 should be adjusted in the c-axis direction such that as much inclusion I as possible are disposed in cut width (kerf width) by wires.

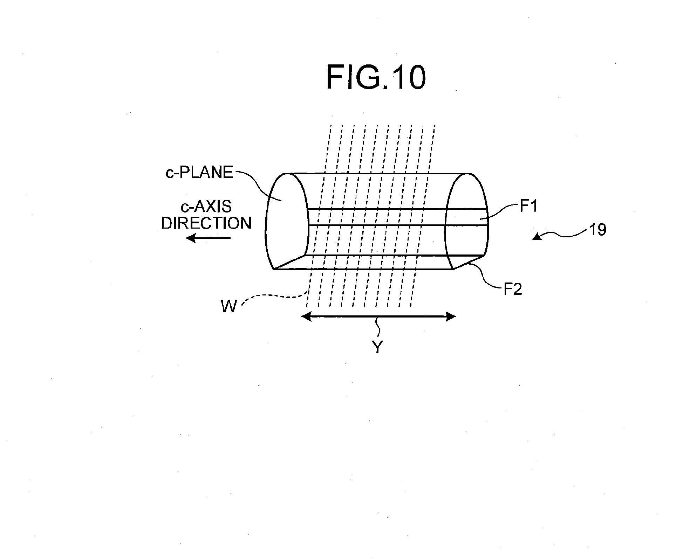

FIG. 10 is a schematic view illustrating an example of processing a group 13 nitride crystal 19 into a substrate. As illustrated in FIG. 10, the position of the group 13 nitride crystal 19 in the c-axis direction relative to a multi-wire saw W is adjusted in the direction along the c-axis direction (arrow Y direction), and the group 13 nitride crystal 19 is cut. Here, it is preferred that one that has been subjected to cylindrical processing, index flat F1 processing, orientation flat F2 processing or the like be used as the group 13 nitride crystal 19. Here, when the pitch at which the wire is wound can be adjusted, the pitch of the wire may be adjusted.

Referring back to FIG. 9, next, post-processing (Step S110) is performed. In the post-processing, for example, the group 13 nitride crystal substrate obtained by the processing into the substrate is subjected to a polishing treatment. A known method is used for the polishing treatment.

For example, in the polishing treatment, mechanical polishing using polishing abrasive grains such as diamond and silicon carbide (SiC), mechanical chemical polishing (CMP) and the like are carried out.

In the present embodiment, in the polishing process as a post-processing of Step S110, when inclusion is contained in the group 13 nitride crystal substrate obtained by the processing into the substrate, it is desirable to specify the inclusion position in the depth direction from the surface and adjust the polishing amount based on the specified position to remove the inclusion. Also, when a plurality of the group 13 nitride crystal substrates are polished at a time, the manufacturing efficiency can be increased by adjusting the load of each of the group 13 nitride crystal substrates to adjust the polishing amount of each of the group 13 nitride crystal substrates in the same polishing process.

Here, in the group 13 nitride crystal substrate in the present embodiment, it is desirable to adjust the polishing amount such that the inclusion I is not contained within 10 µm from the surfaces (both two sides) of the c-plane.

Here, in FIG. 9, the case where processing into a substrate (Step S108) is performed after heat treatment (Step S102), removal of alkali metal (Step S104) and specification of the position of alkali metal (Step S106) is described.

However, after processing into a substrate is performed, a series of the steps of heat treatment (Step S102), removal of alkali metal (Step S104) and specification of the position of alkali metal (Step S106) may be carried out. In addition, heat treatment (Step S102) may be performed multiple times, and also, may be performed both before and after processing into a substrate.

Here, for the group 13 nitride crystal 19 of the present embodiment, more specifically, the group 13 nitride crystal 19 having a dislocation density of basal plane dislocations in a cross section parallel to the c-axis of 10⁴ cm⁻² or more, when the above heat treatment is performed after processing into a substrate, it is considered that inclusion I in the region within 10 µm from the surface of the c-plane is discharged, but inclusion I in the region at 10 µm or more from the surface of the c-plane is not discharged.

Here, depending on the processing direction (cutting direction) of the group 13 nitride crystal 19, the group 13 nitride crystal substrate having a principal surface formed by the c-plane can be obtained.

FIG. 11 is a schematic view illustrating directions in which a group 13 nitride crystal 19 is sliced. Also, FIG. 12 is a schematic view illustrating an example of the group 13 nitride crystal substrate 100 obtained after the slicing.

As an example, the group 13 nitride crystal 19 is sliced perpendicular to the c-axis of the first region 21 (seed crystal 30), as indicated by dotted-dashed line P1 in FIG. 11, whereby the group 13 nitride crystal substrate 100 having a principal surface formed by the c-plane can be obtained, as illustrated in FIG. 12.

According to the manufacturing method of the present embodiment, the group 13 nitride crystal substrate 100 is cut from the group 13 nitride crystal 19 elongated in the c-axis direction as described above, thus the principal surfaces of the substrates can have a large area when the substrates are cut along the c-plane and also when the substrates are cut along a plane other than the c-plane. More specifically, according to the present embodiment, a large-area crystal substrate 100 can be manufactured to have a principal surface formed by any of crystal planes such as the c-plane, m-planes, a-planes, {10-11} planes, {20-21} planes, and {11-22} planes. Therefore, the group 13 nitride crystal substrate 100 that has a practical size and thus can be used for various semiconductor devices can be manufactured.

In addition, the group 13 nitride crystal substrate 100 obtained by the manufacturing method of the present embodiment is preferable as a substrate for various semiconductor devices.

In addition, the group 13 nitride crystal substrate 100 obtained by the manufacturing method of the present embodiment is processed so as not to include inclusion such as alkali metal within 10 µm from the surface. Therefore, the group 13 nitride crystal substrate 100 obtained by the manufacturing method of the present embodiment is preferable as a substrate for various semiconductor devices.

In addition, according to the manufacturing method of the present embodiment, the group 13 nitride crystal substrate 100 is manufactured by slicing a bulk crystal of the group 13 nitride (group 13 nitride crystal 19). Because the process of separating the thick film crystal crystal-grown on the different substrate having big differences in thermal expansion coefficient and lattice constant as in the prior art is not performed, cracks are unlikely to be generated in the group 13 nitride crystal substrate 100 by the manufacturing method of the present embodiment.

### [5] Preferred Shape of Group 13 Nitride Crystal (Bulk Crystal)

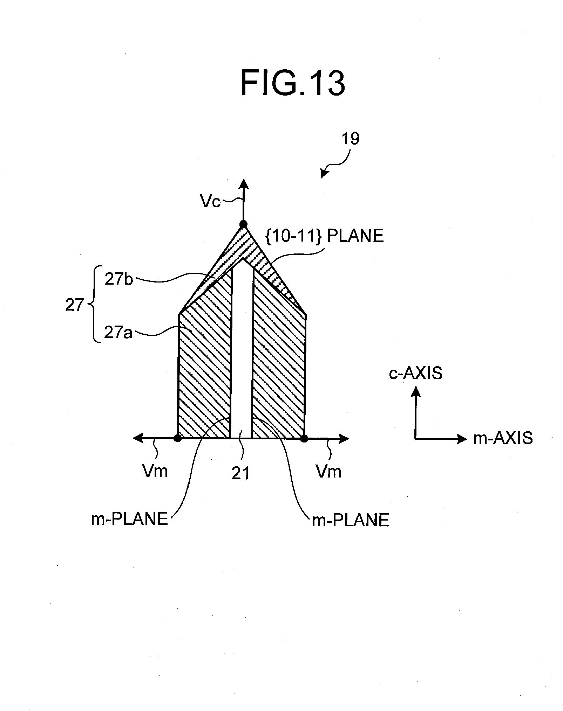

Next, a preferred shape of the group 13 nitride crystal 19 will be described. FIGS. 13 to 15 are a schematic view for describing the process of crystal growth of the second region 27 from the first region 21 (seed crystal 30). In the following description, the crystal growth method is not particularly limited. Here, FIGS. 13 to 15 illustrate a cross section in the surface parallel to the c-axis and a-axis in group 13 nitride crystals 19.

As illustrated in FIG. 13, the group 13 nitride crystal 19 is considered to include: a region 27a mainly grown from the m-planes that are the outer peripheral surface of the first region 21 (seed crystal 30), and a region 27b mainly grown from the {10-11} planes of the first region 21 (seed crystal 30) or a region 27b mainly grown from the {10-11} planes on the upper surfaces of the region 27a.

In the region 27b, the rate of the formation of the {10-11} planes is considered to be rate-determining. It is considered that, thereby, the group 13 nitride crystal grown around the upper portion of the seed crystal (second region 27) is often formed into a hexagonal pyramid shape.

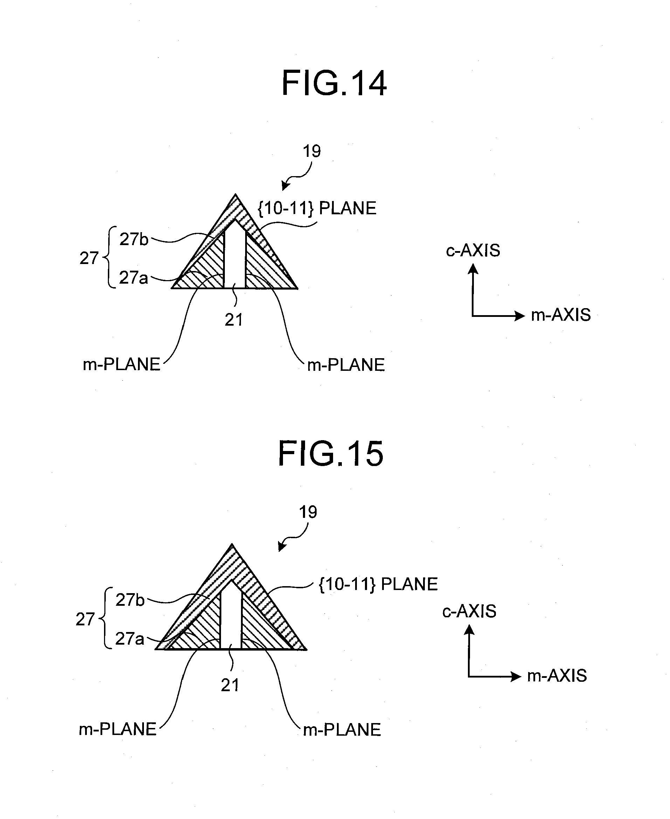

FIG. 14 is a schematic view illustrating the manner of crystal growth when the c-axial length L of the seed crystal is short. When the length L of the seed crystal is not sufficiently long, the ratio of the hexagonal pyramid portion to the hexagonal column portion is large. Therefore, the volume ratio of the region 27b formed in the <10-11> directions is larger than the volume ratio of the region 27a formed in the m-axis directions. Accordingly, the group 13 nitride crystal 19 is likely to have a shape illustrated in FIG. 14. In this case, the region 27b is included in all c-plane cross sections.

Also, FIG. 15 is a schematic view illustrating the manner of crystal growth after the crystal growth of the group 13 nitride crystal (second region 27) in FIG. 14 further proceeds. After the outer circumference of the seed crystal is surrounded by the region 27b as illustrated in FIG. 15, no outer peripheral face composed of the m-planes are formed even after the crystal growth further proceeds. It is often observed that the group 13 nitride crystal (second region 27) grows with the {10-11} planes being maintained as the outer peripheral surface.

The region 27a is a region crystal-grown from the outer peripheral surface of the m-planes of the seed crystal. As described above, the number of threading dislocations in the c-axis direction is considered to be relatively small in the group 13 nitride crystal (region 27a) grown mainly from the m-planes of the seed crystal. Therefore, when a group 13 nitride crystal substrate having a principal surface formed by the c-plane is manufactured, it is preferred that the substrate contain a large amount of the region 27a.

### [6] Preferred Size of Seed Crystal

Next, the shape of the seed crystal (seed crystal 30) that is preferable for growth of the group 13 nitride crystal 19 having the preferred shape described above will be described. The seed crystal 30 (first region 21) has a hexagonal crystal structure, and the angle between the a + c-axis (<11-23> direction) and the c-plane is, for example, 58.4°. Also, when the ratio L/d of the c-axial length L of the seed crystal 30 to its crystal diameter d in the c-plane cross section is 0.813, the seed crystal 30 has a hexagonal pyramid shape.

As described above, to obtain a high-quality group 13 nitride crystal 19, it is preferred that the group 13 nitride crystal (second region 27) grow mainly from the outer peripheral surface of the m-planes of the seed crystal. Therefore, in a preferred embodiment, it is preferred that the seed crystals 30 contain the m-planes as the outer peripheral face thereof.

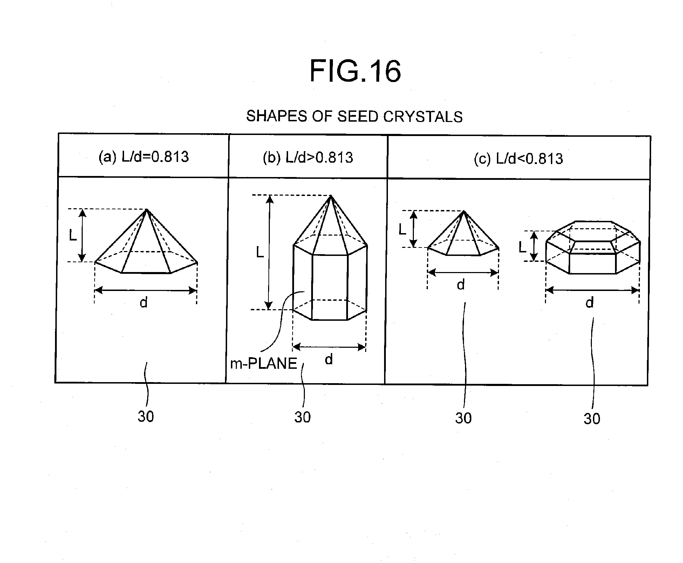

FIG. 16 is a schematic view illustrating the relationships between the shapes of the seed crystals 30 and L/d. L illustrates a maximum length in the c-axis direction. d illustrates a maximum length in the direction perpendicular to the c-axis. As illustrated in FIG. 16, (a) when L/d = 0.813, the seed crystal 30 has a hexagonal pyramid shape. (b) When L/d > 0.813, the upper portion of the seed crystal 30 has a hexagonal pyramid shape, and the lower portion has a hexagonal columnar shape, and the outer peripheral face (side surface) of the seed crystal 30 contains the m-planes. (c) When L/d < 0.813, the seed crystal 30 has a hexagonal pyramid shape containing no m-planes or a shape that does not contain a portion containing the apex of a hexagonal pyramid, has a c-plane formed on the upper surface of the crystal, and includes a low-height hexagonal columnar portion containing the m-planes.

Therefore, in a preferred embodiment, it is preferred that, in the seed crystal 30, the ratio L/d of the c-axial length L to the crystal diameter d in the c-plane be larger than 0.813.

Also, the practical size of the group 13 nitride crystal substrate 100 is preferably half inches (12.7 mm) or two inches (5.08 cm). Therefore, the size of the seed crystal 30 that is required when a group 13 nitride crystal substrate 100 having a principal surface formed by the c-plane has a maximum diameter of half inches (12.7 mm) or more, or two inches or more will be described hereinbelow.

In the following description, a trial calculation is performed when the thickness of the group 13 nitride crystal substrate 100 is 1 mm, which is an example of the minimum thickness required for a practical substrate. However, the required minimum thickness is not limited thereto, and a trial calculation is appropriately performed.

First, to form a group 13 nitride crystal substrate 100 having a diameter of 12.7 mm, i.e., to form a group 13 nitride crystal substrate 100 having a diameter d of 12.7 mm, it is necessary that the second region 27 grow at least 6.35 mm or more in the radial directions (m-axis directions), with the crystal diameter of the seed crystal being regarded as zero and neglected.

Assuming that, for example, the crystal growth rate Vm in the m-axis directions is twice the crystal growth rate Vc in the c-axis direction. Then, while the crystal grows 6.35 mm in the m-axis directions, it grows about 3.2 mm in the c-axis direction. As described above, L/d > 0.813. Therefore, to obtain a crystal diameter d (diameter of the bottom of the hexagonal pyramid portion) of 12.7 mm, the c-axial length L (height of the hexagonal pyramid portion) is 11.9 mm. Therefore, it is estimated that the length of the seed crystal 30 is necessary to be 11.9 - 3.2 = 8.7 mm. Accordingly, the minimum length of the seed crystal required to obtain a group 13 nitride crystal having a hexagonal pyramid shape is 8.7 mm. In addition, it is desirable that a hexagonal columnar region be formed below the hexagonal pyramid portion. Assuming that the required thickness of the group 13 nitride crystal substrate 100 is 1 mm or more, it is estimated that the c-axial length L of the seed crystal 30 requires 9.7 mm.

Like this, in a preferred embodiment, the c-axial length L of the seed crystal 30 is preferably 9.7 mm or more.

In a more preferred embodiment, it is preferred that, in the seed crystal 30, the ratio L/d of the c-axial length L to the crystal diameter d in the c-plane be larger than 0.813 and the c-axial length L be 9.7 mm or more. Further preferably, the L/d is preferably 7 or more and more preferably 20 or more.

Also, to obtain a group 13 nitride crystal substrate 100 having a diameter of two inches (5.08 cm), the required c-axial length L of the seed crystal is estimated to be 37.4 mm or more.

Therefore, in a preferred embodiment, the c-axial length L of the seed crystal 30 is preferably 37.4 mm or more. A group 13 nitride crystal substrate 100 having a c-plane diameter of two inches or more can thereby be manufactured.

### EXAMPLES

Examples will be shown below to describe the present invention in more detail. However, the invention is not limited to these examples. Reference numerals herein correspond to those in the configurations of the crystal manufacturing apparatus 1 and crystal manufacturing apparatus 2 described with reference to FIG. 6 and FIG. 7.

### Production of Seed Crystals

First, seed crystals used to manufacture group 13 nitride crystals were manufactured by the following manufacturing methods.

### Seed Crystal Production Example

Seed crystals were manufactured using the crystal manufacturing apparatus 1 illustrated in FIG. 6.

A reactor vessel 12 formed of sintered BN and having an inner diameter of 92 mm was charged with gallium with a nominal purity of 99.99999% and sodium with a nominal purity of 99.95% in a molar ratio of 0.25 : 0.75.

In a glove box, under a high purity Ar gas atmosphere, the reactor vessel 12 was disposed in the inner vessel 11. The valve 31 was closed to isolate the inside of the reactor vessel 12 from the external atmosphere, and the inner vessel 11 was sealed with being filled with the Ar gas.

Thereafter, the inner vessel 11 was taken out from the glove box and installed in the crystal manufacturing apparatus 1. More specifically, the inner vessel 11 was disposed in a predetermined position relative to the heater 13 and connected to the gas supply tube 14 for nitrogen gas and argon gas at the valve 31 portion.

Next, the argon gas was purged from the inner vessel 11, and then nitrogen gas was introduced from the nitrogen supply tube 17. The pressure of the nitrogen gas was controlled by the pressure regulator 16, and the valve 15 was opened to control the nitrogen pressure in the inner vessel 11 to 3.2 MPa. Thereafter, the valve 15 was closed, and the pressure regulator 16 was set to 8 MPa. Subsequently, the heater 13 was energized to heat the reactor vessel 12 to the crystal growth temperature. In Production Example 1, the crystal growth temperature was set to 870°C.

At the crystal growth temperature, gallium and sodium in the reactor vessel 12 melt to form a molten mixture 24. The temperature of the molten mixture 24 is the same as the temperature of the reactor vessel 12. Also, in the crystal manufacturing apparatus 1 in Production Example 1, when the temperature is raised to the crystal growth temperature, the gas in the inner vessel 11 is heated, and the total pressure becomes 8 MPa.

Next, the valve 15 was opened with the nitrogen gas pressure being set to 8 MPa, and the inside of the inner vessel 11 and the inside of the nitrogen supply tube 17 were brought into a pressure equilibrium state.

The reactor vessel 12 was held in this state for 500 hours to grow crystals of gallium nitride. Then, the heater 13 was controlled to decrease the temperature of the inner vessel 11 to room temperature (about 20°C). After the pressure of the gas inside of the inner vessel 11 was reduced, the inner vessel 11 was opened. A large number of gallium nitride crystals were found to be grown in the reactor vessel 12. The seed crystals 30 that were the crystal-grown gallium nitride crystals were colorless and transparent. The crystal diameter d was about 100 to about 1,500 µm, the length L was about 10 to about 40 mm, and the ratio L/d of the length L to the crystal diameter d was about 20 to about 300. The seed crystals 30 that were the crystal-grown gallium nitride crystals were grown substantially parallel to the c-axis and had m-planes formed on the side surfaces.

### Manufacture of Group 13 Nitride Crystals

Next, group 13 nitride crystals were manufactured.

### Example A1

In this example, the second region 27 was crystal-grown from a seed crystal 30 using the crystal manufacturing apparatus 2 illustrated in FIG. 7 to manufacture a group 13 nitride crystal 19.

As the seed crystal 30, the seed crystal 30 manufactured in Seed Crystal Production Example 1 was used. This seed crystal 30 had a width of 1 mm and a length of about 40 mm.

First, the inner vessel 51 was separated from the crystal manufacturing apparatus 2 at the valve 61 portion and placed in a glove box with an Ar atmosphere. Subsequently, the seed crystal 30 was disposed in an alumina-made reactor vessel 52 having an inner diameter of 140 mm and a depth of 100 mm. The seed crystal 30 was inserted into a hole having a depth of 4 mm and formed on the bottom of the reactor vessel 52 and held therein.

Next, sodium (Na) was heated and liquefied, and the liquefied sodium was placed in the reactor vessel 52. After the sodium was solidified, gallium was placed. In this example, the molar ratio of gallium to sodium was 0.25 : 0.75.

Then, in the glove box, under a high purity Ar gas atmosphere, the reactor vessel 52 was disposed in the inner vessel 51. The valve 61 was closed to seal the inner vessel 51 filled with the Ar gas, and the inside of the reactor vessel 52 was isolated from the external atmosphere. Next, the inner vessel 51 was taken out from the glove box and installed in the crystal manufacturing apparatus 2. More specifically, the inner vessel 51 was disposed in a predetermined position relative to the heater 53 and connected to the gas supply tube 54 at the valve 61 portion.

Next, the argon gas was purged from the inner vessel 51, and nitrogen gas was introduced from the nitrogen supply tube 57. The pressure of the nitrogen gas was controlled by the pressure regulator 56, and the valve 55 was opened to control the total pressure in the inner vessel 51 to 1.2 MPa. Then, the valve 55 was closed, and the pressure regulator 56 was set to 3.0 MPa.

Next, the heater 53 was energized to heat the reactor vessel 52 to the crystal growth temperature. The crystal growth temperature was set to 870°C. Then, as in the production in Seed Crystal Production Example 1 above, the valve 55 was opened with the nitrogen gas pressure being set to 3.0 MPa, and the reactor vessel 52 was held in this state for 1,500 hours to grow a gallium nitride crystal.

As a result, a crystal was grown from the seed crystal 30, and the crystal diameter was increased in directions perpendicular to the c-axis, thus a group 13 nitride crystal 19 (single crystal) having a larger crystal diameter was grown in the reactor vessel 52. The group 13 nitride crystal 19 obtained by crystal growth was substantially colorless and transparent. The crystal diameter d was 55 mm, and the c-axial length L including the length of the seed crystal 30 inserted into the reactor vessel 52 was about 54 mm. Here, the crystal growth rate in the a-axis direction <11-20> during crystal growth was about 18.3 µm/hr. The group 13 nitride crystal 19 had a shape including a hexagonal pyramid-shaped upper portion and a hexagonal columnar lower portion.

### Example A2

The seed crystal 30 was crystal-grown using the crystal manufacturing apparatus 2 illustrated in FIG. 7 under the same conditions as in Example A1 except that the crystal growth temperature was 860°C, the nitrogen gas pressure during crystal growth was 2.7 MPa, and the crystal growth time (retention time of reactor vessel 52 under the above conditions) was 1,200 hours, to manufacture a group 13 nitride crystal 19.

As a result, a crystal was grown from the seed crystal 30, and the crystal diameter was increased in directions perpendicular to the c-axis, thus a group 13 nitride crystal 19 (single crystal) having a larger crystal diameter was grown in the reactor vessel 52. The group 13 nitride crystal 19 obtained by crystal growth was substantially colorless and transparent. The crystal diameter d was 56 mm, and the c-axial length L including the length of the seed crystal 30 inserted into the reactor vessel 52 was about 46 mm. Here, the crystal growth rate in the a-axis direction <11-20> during crystal growth was about 23.3 µm/hr. The group 13 nitride crystal 19 had a shape including a hexagonal pyramid-shaped upper portion and a hexagonal columnar lower portion.

### Example A3

The seed crystal 30 was crystal-grown using the crystal manufacturing apparatus 2 illustrated in FIG. 7 under the same conditions as in Example A1 except that the crystal growth temperature was 850°C, the nitrogen gas pressure during crystal growth was 2.4 MPa, and the crystal growth time (retention time of reactor vessel 52 under the above conditions) was 1,000 hours, to manufacture a group 13 nitride crystal 19.

As a result, a crystal was grown from the seed crystal 30, and the crystal diameter was increased in directions perpendicular to the c-axis, thus a group 13 nitride crystal 19 (single crystal) having a larger crystal diameter was grown in the reactor vessel 52. The group 13 nitride crystal 19 obtained by crystal growth was substantially colorless and transparent. The crystal diameter d was 57 mm, and the c-axial length L including the length of the seed crystal 30 inserted into the reactor vessel 52 was about 45 mm. Here, the crystal growth rate in the a-axis direction <11-20> during crystal growth was about 28.5 µm/hr. The group 13 nitride crystal 19 had a shape including a hexagonal pyramid-shaped upper portion and a hexagonal columnar lower portion.

### Example A4

The seed crystal 30 was crystal-grown using the crystal manufacturing apparatus 2 illustrated in FIG. 7 under the same conditions as in Example A1 except that the crystal growth temperature was 890°C, the nitrogen gas pressure during crystal growth was 4.2 MPa, and the crystal growth time (retention time of reactor vessel 52 under the above conditions) was 2,000 hours, to manufacture a group 13 nitride crystal 19.

As a result, a crystal was grown from the seed crystal 30, and the crystal diameter was increased in directions perpendicular to the c-axis, thus a group 13 nitride crystal 19 (single crystal) having a larger crystal diameter was grown in the reactor vessel 52. The group 13 nitride crystal 19 obtained by crystal growth was substantially colorless and transparent. The crystal diameter d was 62 mm, and the c-axial length L including the length of the seed crystal 30 inserted into the reactor vessel 52 was about 53 mm. Here, the crystal growth rate in the a-axis direction <11-20> during crystal growth was 15.5 µm/hr. The group 13 nitride crystal 19 had a shape including a hexagonal pyramid-shaped upper portion and a hexagonal columnar lower portion.

### Example A5

The seed crystal 30 was crystal-grown using the crystal manufacturing apparatus 2 illustrated in FIG. 7 under the same conditions as in Example A1 except that the crystal growth temperature was 880°C, the nitrogen gas pressure during crystal growth was 3.5 MPa, and the crystal growth time (retention time of reactor vessel 52 under the above conditions) was 1,700 hours, to manufacture a group 13 nitride crystal 19.

As a result, a crystal was grown from the seed crystal 30, and the crystal diameter was increased in directions perpendicular to the c-axis, thus a group 13 nitride crystal 19 (single crystal) having a larger crystal diameter was grown in the reactor vessel 52. The group 13 nitride crystal 19 obtained by crystal growth was substantially colorless and transparent. The crystal diameter d was 58 mm, and the c-axial length L including the length of the seed crystal 30 inserted into the reactor vessel 52 was about 51 mm. Here, the crystal growth rate in the a-axis direction <11-20> during crystal growth was 17.0 µm/hr. The group 13 nitride crystal 19 had a shape including a hexagonal pyramid-shaped upper portion and a hexagonal columnar lower portion.

### Comparative Example A1

The seed crystal 30 was crystal-grown using the crystal manufacturing apparatus 2 illustrated in FIG. 7 under the same conditions as in Example A1 except that the a reactor vessel 52 made of YAG was used, the molar ratio of gallium to sodium was 0.30 : 0.70, the crystal growth temperature was 900°C, the nitrogen gas pressure during crystal growth was 8.0 MPa, and the crystal growth time (retention time of reactor vessel 52 under the above conditions) was 2,000 hours, to manufacture a comparative group 13 nitride crystal.

As a result, a crystal was grown from the seed crystal 30, and the crystal diameter was increased in directions perpendicular to the c-axis, thus a comparative group 13 nitride crystal 19 (single crystal) having a larger crystal diameter was grown in the reactor vessel 52. The comparative group 13 nitride crystal obtained by crystal growth was substantially colorless and transparent. The crystal diameter d was 60 mm, and the c-axial length L including the length of the seed crystal 30 inserted into the reactor vessel 52 was about 48 mm. Here, the crystal growth rate in the a-axis direction <11-20> during crystal growth was 15.0 µm/hr. The comparative group 13 nitride crystal had a shape including a hexagonal pyramid-shaped upper portion and a hexagonal columnar lower portion.

### Comparative Example A2

The seed crystal 30 was crystal-grown using the crystal manufacturing apparatus 2 illustrated in FIG. 7 under the same conditions as in Comparative Example A2 except that the crystal growth temperature was 900°C, the nitrogen gas pressure during crystal growth was 7.0 MPa, and the crystal growth time (retention time of reactor vessel 52 under the above conditions) was 2,200 hours, to manufacture a comparative group 13 nitride crystal.

As a result, a crystal was grown from the seed crystal 30, and the crystal diameter was increased in directions perpendicular to the c-axis, thus a group 13 nitride crystal 19 (single crystal) having a larger crystal diameter was grown in the reactor vessel 52. The comparative group 13 nitride crystal obtained by crystal growth was substantially colorless and transparent. The crystal diameter d was 57 mm, and the c-axial length L including the length of the seed crystal 30 inserted into the reactor vessel 52 was about 47 mm. Here, the crystal growth rate in the a-axis direction <11-20> during crystal growth was 13.0 µm/hr. The comparative group 13 nitride crystal had a shape including a hexagonal pyramid-shaped upper portion and a hexagonal columnar lower portion.

### Comparative Example A3

A substrate-like seed crystal was prepared as Production Example 2. First, the group 13 nitride crystal 19 prepared in Example A1 was sliced with a multi-wire saw, to prepare a group 13 nitride crystal substrate having a principal surface formed by the c-plane. As the multi-wire saw, MWS-34SN manufactured by Takatori Corporation was used, with a wire pitch of 700 µm and a wire diameter of 160 µm The thickness of the prepared group 13 nitride crystal substrate was 550 µm. Two sides of the prepared group 13 nitride crystal substrate were polished, and the polished amount of two sides was adjusted so as not to contain inclusion within 10 µm from the surface. Moreover, the group 13 nitride crystal substrate after polishing was defined as a substrate-like seed crystal. This seed crystal had a c-plane diameter of 50.8 mm and a thickness of 300 µm.

Using this substrate-like seed crystal, the second region 27 was crystal-grown from the seed crystal using the crystal manufacturing apparatus 2 illustrated in FIG. 7 to manufacture a comparative group 13 nitride crystal.

First, the inner vessel 51 was separated from the crystal manufacturing apparatus 2 at the valve 61 portion and placed in a glove box with an Ar atmosphere. Subsequently, the above substrate-like seed crystal was disposed in an alumina-made reactor vessel 52 having an inner diameter of 140 mm and a depth of 100 mm.

Next, sodium (Na) was heated and liquefied, and the liquefied sodium was placed in the reactor vessel 52. After the sodium was solidified, gallium was placed. In this Example, the molar ratio of gallium to sodium was 0.25 : 0.75.

Then, in the glove box, under a high purity Ar gas atmosphere, the reactor vessel 52 was disposed in the inner vessel 51. The valve 61 was closed to seal the inner vessel 51 filled with the Ar gas, and the inside of the reactor vessel 52 was isolated from the external atmosphere. Next, the inner vessel 51 was taken out from the glove box and installed in the crystal manufacturing apparatus 2. More specifically, the inner vessel 51 was disposed in a predetermined position relative to the heater 53 and connected to the gas supply tube 54 at the valve 61 portion.

Next, the argon gas was purged from the inner vessel 51, and then nitrogen gas was introduced from the nitrogen supply tube 57. The pressure of the nitrogen gas was controlled by the pressure regulator 56, and the valve 55 was opened to control the total pressure in the inner vessel 51 to 1.0 MPa. Thereafter, the valve 55 was closed, and the pressure regulator 56 was set to 3 MPa.

Next, the heater 53 was energized to heat the reactor vessel 52 to the crystal growth temperature. The crystal growth temperature was set to 870°C. Then, as in Example A1, the valve 55 was opened with the nitrogen gas pressure being set to 2.5 MPa, and the reactor vessel 52 was held in this state for 700 hours to grow a crystal.

As a result, the thickness of the substrate was increased in the c-axis direction, and a group 13 gallium crystal (single crystal) was grown in the reactor vessel 52. The comparative group 13 nitride crystal obtained by crystal growth was substantially colorless and transparent, and the c-axial length L was about 8 mm.

### Heat Treatment

Next, the group 13 nitride crystals and the comparative group 13 nitride crystals manufactured in Examples A and Comparative Examples A were subjected to a heat treatment in the following heat treatment conditions.

Specifically, the group 13 nitride crystals and the comparative group 13 nitride crystals manufactured in Examples A and Comparative Examples A were each retained at a temperature of 850°C, 860°C, 1000°C and 1100°C for 1 hour, under an atmosphere of a mixed gas of 5 slm of nitrogen gas and 1 slm of ammonia gas.

The presence or absence of ejection or expansion of inclusion and ejection direction of inclusion at the heat treatment, and cracking of the crystal after heat treatment were each evaluated. The evaluation result was shown in Table 1.

Here, the presence or absence of ejection or expansion of inclusion was evaluated by appearance observation. The evaluation result was shown in Table 1. Also, the ejection direction of inclusion at the heat treatment was evaluated by appearance observation or observing using a laser microscope. The evaluation result was shown in Table 1.

In addition, cracking of the crystal after heat treatment was evaluated by appearance observation or observing using a laser microscope. The evaluation result was shown in Table 1.

### Group 13 Nitride Crystal Substrate

Next, the group 13 nitride crystals and the comparative group 13 nitride crystals manufactured in Examples A and Comparative Examples A and subjected to the above heat treatment were subjected to the following processing, to manufacture group 13 nitride crystal substrates.

### Removal of Alkali Metal

First, for the group 13 nitride crystals and the comparative group 13 nitride crystals manufactured in Examples A and Comparative Examples A and subjected to the above heat treatment, a series of treatments in which each was immersed in a 20% hydrochloric acid solution diluted with pure water (hydrochloric acid solution : pure water = 1 : 4) for 60 minutes and then subjected to ultrasonic cleaning in pure water for 10 minutes was repeated 3 times. Inclusion (alkali metal) ejected on the surface of each of the group 13 nitride crystals and the comparative group 13 nitride crystals manufactured in Examples A and Comparative Examples A were thereby removed.

### Example B1 to Example B5

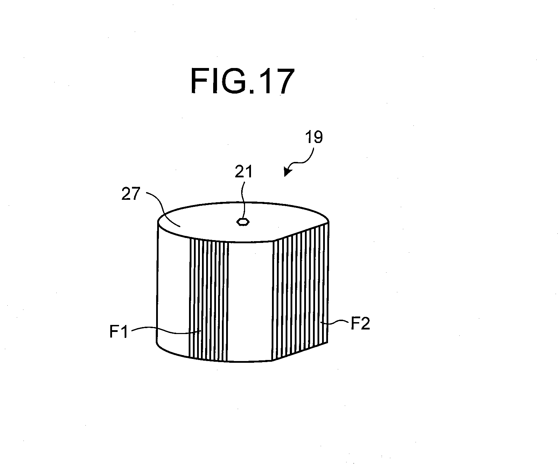

The group 13 nitride crystals that were manufactured in Examples A (Example A1 to Example A5) and subjected to the above heat treatment and removal of alkali metal were each processed into a substrate. First, both ends in the c-axis direction in each of the group 13 nitride crystals that were manufactured in Example A1 to Example A5 and subjected to the above heat treatment and removal of alkali metal were cut and ground so as to be the surface of the c-plane. Next, the resulting crystal was processed into a cylinder, and further, an orientation flat surface and index flat surface were ground on the surfaces parallel to the c-axis. The crystal was thereby polished into the external form illustrated in FIG. 17. Here, the height in the c-axis direction was 25 mm, and the diameter of the c-plane was 50.8 mm.

Next, for each of the group 13 nitride crystals that were manufactured in Example A1 to Example A5 and subjected to the above processing and polishing, the position of the contained inclusion (alkali metal) was specified using X-ray computed tomography scanner manufactured by SHIMADZU CORPORATION.

The number of the contained inclusion was compared, and the inclusion contained in the group 13 nitride crystal manufactured in Example A1 was found out to be slight. On the other hand, the inclusion contained in the group 13 nitride crystal manufactured in Example A2 was more than the inclusion contained in the group 13 nitride crystal manufactured in Example A1. In addition, the inclusion contained in the group 13 nitride crystals manufactured in Example A3 was more than the inclusion contained in the group 13 nitride crystals manufactured in Example A2.

Next, the group 13 nitride crystals that were manufactured in Example A1 to Example A5 and subjected to the above processing, polishing, and specification of inclusion position were processed into a substrate. Specifically, the group 13 nitride crystals that were manufactured in Example A1 to Example A5 and subjected to the above processing, polishing and specification of inclusion position were sliced in the direction parallel to the m-plane, and the surface was polished, to prepare a group 13 nitride crystal substrate having a principal surface formed by the m-plane with a height of 40 mm, a width of 25 mm and a thickness of 400 µm (see group 13 nitride crystal substrate 101 in FIG. 4) and a group 13 nitride crystal substrate having a principal surface formed by the m-plane with a height of 40 mm, a width of 40 mm and a thickness of 400 µm (see group 13 nitride crystal substrate 102 in FIG. 5).

### Evaluation

For the group 13 nitride crystal substrates manufactured in Example B1 to Example B5, the dislocation density was measured.

Specifically, the surface of the m-plane of each of the group 13 nitride crystal substrates manufactured in Example B1 to Example B5 (see group 13 nitride crystal substrate 101 in FIG. 4) was observed by cathodoluminescence. Cathodoluminescence was observed in the conditions of an accelerating voltage of 5.0 kV, a probe current of 4.8 nA and room temperature, using as an apparatus MERLIN manufactured by Carl Zeiss.

The dislocation density of basal plane dislocations in a cross section parallel to the c-axis (m-plane) (dislocation in the c-plane direction, i.e., dislocation that penetrates the surface of the m-plane) of the group 13 nitride crystal substrate of Example B1 that was the group 13 nitride crystal substrate manufactured from the group 13 nitride crystal manufactured in Example A1 was of the order of 10⁴ cm⁻² to 10⁵ cm⁻². The evaluation result was shown in Table 1.

The dislocation density of basal plane dislocations in a cross section parallel to the c-axis (m-plane) (dislocation in the c-plane direction, i.e., dislocation that penetrates the surface of the m-plane) of the group 13 nitride crystal substrate of Example B2 that was the group 13 nitride crystal substrate manufactured from the group 13 nitride crystal manufactured in Example A2 was of the order of 10⁵ cm⁻² to 10⁶ cm⁻². The evaluation result was shown in Table 1.

The dislocation density of basal plane dislocations in a cross section parallel to the c-axis (m-plane) (dislocation in the c-plane direction, i.e., dislocation that penetrates the surface of the m-plane) of the group 13 nitride crystal substrate of Example B3 that was the group 13 nitride crystal substrate manufactured from the group 13 nitride crystal manufactured in Example A3 was of the order of 10⁶ cm⁻² to 10⁷ cm⁻². The evaluation result was shown in Table 1.

In addition, the dislocation densities of basal plane dislocations in a cross section parallel to the c-axis (m-plane) (dislocations in the c-plane direction, i.e., dislocations that penetrate the surface of the m-plane) of the group 13 nitride crystal substrates of Example B4 and Example B5 that were the group 13 nitride crystal substrates manufactured from the group 13 nitride crystals manufactured in Example A4 and Example A5 were measured in the same manner. The measurement result was shown in Table 1.

Specifically, as a result of observing the surface of the m-plane of each of the group 13 nitride crystal substrates manufactured in Example B1 to Example B5, there was a region where dislocations were concentrated, and the presence of crystal grain boundary was found from the contrast of observed images of cathodoluminescence. As a result of observing the surface of the m-plane of each of the group 13 nitride crystal substrates manufactured in Example B1 to Example B5, the grain boundary density was of the order of 10 cm⁻² to 100 cm⁻².

Next, the surfaces of the m-planes of the group 13 nitride crystal substrates manufactured in Example B1 to Example B5 (see group 13 nitride crystal substrate 102 in FIG. 5) were observed by cathodoluminescence. As a result, many dislocations were observed as dark lines extending in the direction parallel to the c-plane. Furthermore, the region where dislocations in the direction parallel to the c-plane were aggregated in a laminated form was also present, and the presence of crystal grain boundary was found in the direction parallel to the c-plane. Here, there was a region where dislocations were aggregated around the boundary of the region that was a seed crystal (first region 21) and the region that was grown from a seed crystal (second region 27). In a region where dislocations were aggregated around the boundary of the region that was a seed crystal (first region 21) and the regions grown from a seed crystal (second region 27), a dislocation not parallel to the c-plane such as <11-23> was also present. In addition, it could be also confirmed that a plurality of dislocations was generated in the direction from the region that was a seed crystal (first region 21) to the region grown from a seed crystal (second region 27).

### Comparative Example B1 to Comparative Example B2

Each of the comparative group 13 nitride crystals that were manufactured in Comparative Example A1 to Comparative Example A2 and subjected to the above heat treatment and removal of alkali metal was processed into a substrate in the same manner as in Example B1, to manufacture a comparative group 13 nitride crystal substrate.

For the manufactured comparative group 13 nitride crystal substrate, the dislocation was evaluated as in the same manner as Example B1.

The dislocation density of basal plane dislocations of the comparative group 13 nitride crystal substrate of Comparative Example B1 (substrate manufactured from the comparative group 13 nitride crystal substrate of Comparative Example A1) was of the order of 10³ cm⁻² or so. In addition, in the observation of cathodoluminescence in the c-plane, when a dislocation not parallel to the c-axis and c-plane such as <11-23> direction was present in the surface of the c-plane, a dislocation was observed as a short dark line or the like, but such short dark line was not observed in the comparative group 13 nitride crystal substrate of Comparative Example B1. In addition, the dislocation density of threading dislocations in the m-plane of the comparative group 13 nitride crystal substrate of Comparative Example B1 was of the order of 10³ cm⁻² or so. The evaluation result was shown in Table 1.

The dislocation density of basal plane dislocations of the comparative group 13 nitride crystal substrate of Comparative Example B2 (substrate manufactured from the comparative group 13 nitride crystal substrate of Comparative Example A2) was 10³ cm⁻² or so. In addition, the dislocation density of threading dislocations in the m-plane was of the order of 10³ cm⁻² or so. The evaluation result was shown in Table 1.

### Comparative Example B3

Both ends in the c-axis direction of the comparative group 13 nitride crystal that was manufactured in Comparative Example A3 were ground so as to be the surface of the c-plane. Next, the resulting crystal was processed into a cylinder, and further, an orientation flat and an index flat were ground on the surfaces in the directions parallel to the c-axis. Here, the height in the c-axis direction was 7 mm, and the diameter of the c-plane was 15 mm.

After the grinding, the comparative group 13 nitride crystal was sliced parallel to the m-plane, and the surface was polished, to manufacture a comparative group 13 nitride crystal substrate having a principal surface formed by the m-plane with a height of 7 mm, a width of 15 mm and a thickness of 400 µm For the comparative group 13 nitride crystal substrate, the dislocation density of basal plane dislocations and the dislocation density of threading dislocations were measured in the same manner as the above. However, a dislocation was hardly found, and the dislocation density was 10² cm⁻² or less. When a crystal is grown in the c-axis direction, it is inferred that a dislocation hardly exists. The measurement result was shown in Table 1.

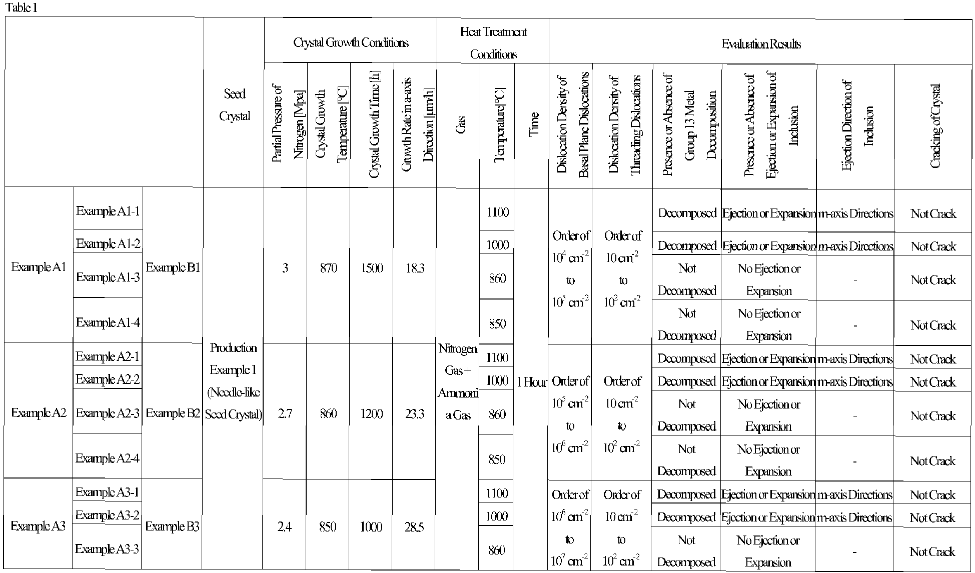

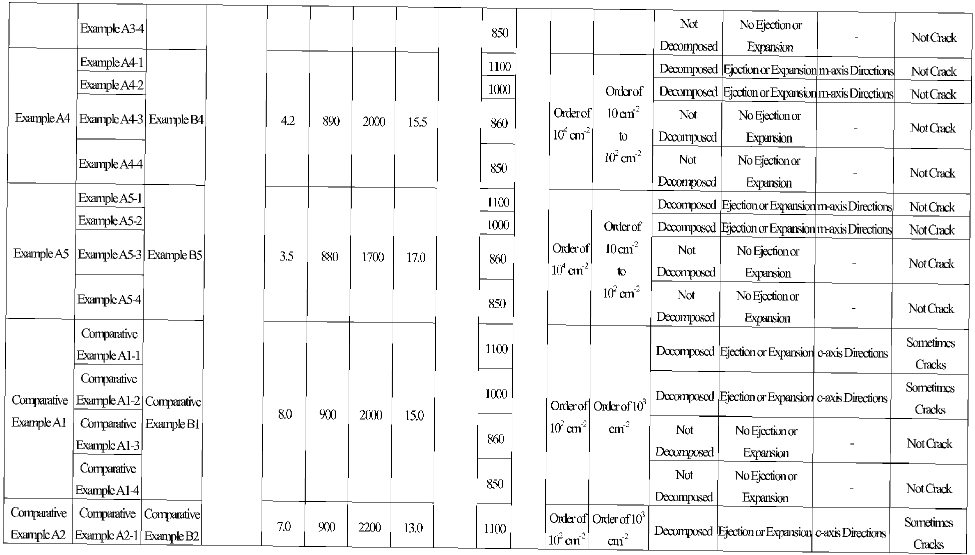

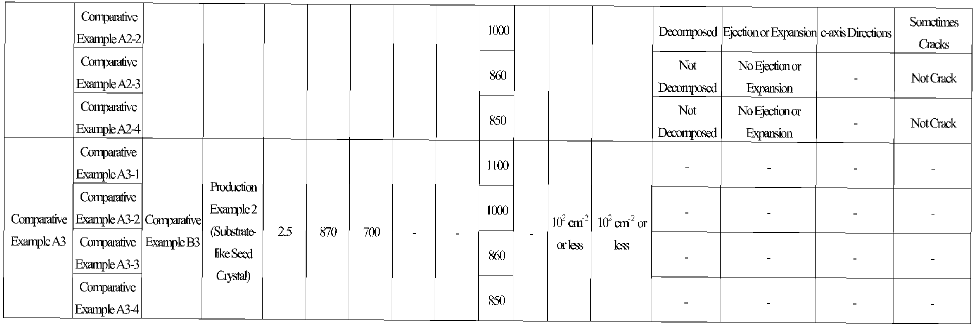

As shown in Table 1, in the group 13 nitride crystals prepared in Examples, the crystal growth rates were faster as compared to the comparative group 13 nitride crystals prepared in Comparative Examples, and the dislocation density of basal plane dislocations in a cross section parallel to the c-axis (m-axis or the like) was 10⁴ cm⁻² or more. Therefore, it can be said that the group 13 nitride crystals prepared in Examples are a crystal preferable for a semiconductor device.

In addition, in the group 13 nitride crystals prepared in Examples, inclusion (alkali metal) was ejected in the m-axis directions by heat treatment, and the alkali metal could be effectively reduced, as compared to Comparative Examples. Also, in the group 13 nitride crystals prepared in Examples, irregularities due to the ejection of alkali metal were suppressed, as compared to the group 13 nitride crystals prepared in Comparative Examples. Moreover, in the group 13 nitride crystals prepared in Examples, convex swelling of substrate in the c-axis direction due to the ejection of alkali metal in the c-axis direction was suppressed, and also surface delamination with the ejection of inclusion to become hollow was suppressed, as compared to the group 13 nitride crystals prepared in Comparative Examples.

Therefore, it can be said that the group 13 nitride crystals and group 13 nitride crystal substrates prepared in Examples are a crystal and substrate preferable for a semiconductor device, as compared to the group 13 nitride crystals and group 13 nitride crystal substrates prepared in Comparative Examples.

Heat Treatment of Group 13 Nitride Crystal Substrates and Comparative Group 13 Nitride Crystal Substrates

### Example C1

Among the group 13 nitride crystal substrates prepared in Example B1, a group 13 nitride crystal substrate that did not include inclusion in the region from the surface to 10 µm depth and included inclusion in the position of 11 µm to 20 µm depth was separated. In the same manner, also for the group 13 nitride crystal substrates prepared in each of Example B2 and Example B2, a group 13 nitride crystal substrate that did not include inclusion in the region from the surface to 10 µm depth and included inclusion in the position of 11 µm to 20 µm depth was separated.

Then, the separated group 13 nitride crystal substrates were heat-treated at 1200°C for one hour, under an atmosphere of a mixed gas of 5 slm of nitrogen gas and 1 slm of ammonia gas. As a result, for all of the group 13 nitride crystal substrates, while a rough surface was seen, ejection of inclusion to the surface of the c-plane was not observed.

### Example C2

Among the group 13 nitride crystal substrates prepared in Example B1, a group 13 nitride crystal substrate that included inclusion in the region from the surface to 10 µm depth was separated. In the same manner, also for the group 13 nitride crystal substrates prepared in each of Example B2 and Example B3, a group 13 nitride crystal substrate that included inclusion in the region from the surface to 10 µm depth was separated.

Then, the separated group 13 nitride crystal substrates were heat-treated at 1200°C for one hour, under an atmosphere of a mixed gas of 5 slm of nitrogen gas and 1 slm of ammonia gas. As a result, there were substrates that ejected or did not eject inclusion to the surface of the c-plane.

As shown in Example C1 and Example C2, it could be confirmed that, among the group 13 nitride crystal substrates prepared in Examples, a substrate that does not contain inclusion within 10 µm from the surface does not eject inclusion to the surface of the c-plane even when exposed in a hot environment. On the other hand, a substrate that contains inclusion within 10 µm from the surface sometimes ejects inclusion to the surface of the c-plane when exposed in a hot environment. Therefore, it can be said that, among the group 13 nitride crystal substrates prepared in Examples, a substrate that does not contain inclusion within 10 µm from the surface is more preferable for a semiconductor device, as compared to a substrate that contains inclusion within 10 µm from the surface.

### Comparative Example C1

In the comparative group 13 nitride crystal substrate prepared in Comparative Example B1, a comparative group 13 nitride crystal substrate that did not include inclusion in the region from the surface to 10 µm depth and included inclusion in the position of 11 µm to 20 µm depth was separated.

Then, the separated comparative group 13 nitride crystal substrates were heat-treated at 1000°C for one hour, under an atmosphere of a mixed gas of 5 slm of nitrogen gas and 1 slm of ammonia gas. As a result, while there was no ejection of inclusion to the surface of the substrate, a phenomenon that the comparative group 13 nitride crystal substrate convexly swells in the c-axis direction and a substrate in which the surface of the substrate was delaminated with the ejection of inclusion could be confirmed.

This convex swelling was a swelling of from 10 µm to 40 µm, as compared to the comparative group 13 nitride crystal substrate before heat treatment. It was estimated that the substrate convexly swells by heat treatment and the surface of the substrate was delaminated because the dislocation density of basal plane dislocations was less than 10⁴ cm⁻².

Here, the evaluation of the surface of the substrate and the effect of the surface of the substrate described later were performed by XRC measurement of XRD system.

As described above, the comparative group 13 nitride crystal substrate prepared in Comparative Example B1 has more strain and irregularities on the surface of crystal, as compared to the group 13 nitride crystal substrates prepared in Examples. Also, adjustment of strain and irregularities by processing and polishing leads to the increase in the manufacturing processes. Therefore, it can be said that the comparative group 13 nitride crystal substrate prepared in Comparative Example B1 is not suitable as a semiconductor device, as compared to the group 13 nitride crystal substrates prepared in Examples.

### Comparative Example C2

In the comparative group 13 nitride crystal substrate prepared in Comparative Example B2, those containing inclusion in the substrate was separated, and heat-treated in the same manner as in Comparative Example C1.

As a result, while there was no ejection of inclusion to the surface of the comparative group 13 nitride crystal substrate, a phenomenon that the substrate convexly swells in the c-axis direction was seen. This convex swelling was a swelling of from 10 µm to 30 µm or so, as compared to the comparative group 13 nitride crystal substrate before heat treatment. It was estimated that the substrate convexly swells by heat treatment and the surface of the substrate was delaminated because the dislocation density of basal plane dislocations was less than 10⁴ cm⁻².

As described above, the comparative group 13 nitride crystal substrate prepared in Comparative Example B2 has more strain and irregularities on the surface of crystal, as compared to the group 13 nitride crystal substrates prepared in Examples. Also, adjustment of strain and irregularities by processing and polishing leads to the increase in the manufacturing processes. Therefore, it can be said that the comparative group 13 nitride crystal substrate prepared in Comparative Example B2 is not suitable as a semiconductor device, as compared to the group 13 nitride crystal substrates prepared in Examples.

According to the embodiment, a group 13 nitride crystal and group 13 nitride crystal substrate suitable for manufacturing a semiconductor device and a method of manufacturing a group 13 nitride crystal can be provided.

Although the invention has been described with respect to specific embodiments for a complete and clear disclosure, the appended claims are not to be thus limited but are to be construed as embodying all modifications and alternative constructions that may occur to one skilled in the art that fairly fall within the basic teaching herein set forth.

The present application claims priority to and incorporates by reference the entire contents of Japanese Patent Application No. 2012-203754 filed in Japan on September 17, 2012.

## Claims

1. A group 13 nitride crystal (19) having a hexagonal crystal structure and containing at least a nitrogen atom and at least one metal atom selected from a group consisting of B, Al, Ga, In and Tl, wherein
dislocation density of basal plane dislocations (P) in a cross section parallel to a c-axis is 10⁴ cm⁻² or more.

2. The group 13 nitride crystal (19) according to claim 1, wherein the dislocation density of basal plane dislocations (P) in the cross section parallel to the c-axis is higher than dislocation density of threading dislocations (Q) of the c-plane in the cross section.

3. The group 13 nitride crystal (19) according to claim 1 or claim 2, wherein the dislocation density of threading dislocations (Q) is 10³ cm⁻² or less.

4. The group 13 nitride crystal (19) according to any one of claim 1 to claim 3, which includes an alkali metal (I).

5. A group 13 nitride crystal substrate (100) which has a principal surface formed by a c-plane of the group 13 nitride crystal (19) according to any one of claim 1 to claim 4.

6. The group 13 nitride crystal substrate (100) according to claim 5, which includes an alkali metal (I).

7. The group 13 nitride crystal substrate (100) according to claim 6, wherein the alkali metal (I) is not contained in a region within 10 µm from a surface.

8. A method of manufacturing a group 13 nitride crystal (19) comprising a crystal growth process of crystal-growing a needle-like seed crystal (21) of group 13 nitride extending in a c-axis direction, in such a direction that a cross-sectional area of a c-plane is enlarged, wherein
a crystal growth rate in an a-axis direction of the seed crystal (21) in the crystal growth process is higher than 15 µm/hr.

9. The method of manufacturing a group 13 nitride crystal (19) according to claim 8, further comprising
a heat treatment process to discharge an included alkali metal (I) in the m-axis directions.
